# EUROPEAN PATENT APPLICATION

(11) **EP 1 130 714 A2**
(43) Date of publication of application: **05.09.2001**
(21) Application number: 00403634.9
(22) Date of filing: 21.12.2000
(51) Int. Cl.: H01S 5/12, H01S 5/02

(54) **Laser elements having different wavelenghts formed from one semiconductor substrate**

(30) Priority: 28.12.1999 JP 37347899
(71) Applicant: NEC CORPORATION, Tokyo (JP)
(72) Inventor: Sakata, Yasutaka, Tokyo (JP)
(74) Representative: Des Termes, Monique

(57) **Abstract**

A set of semiconductor laser elements and manufacturing method. The set of semiconductor laser elements have mutually different oscillation wavelengths, and perform single longitudinal mode oscillation by having periodically varying refractive index within the elements. The set of semiconductor laser elements are formed together from one semiconductor substrate. Duty cycle of a diffraction grating in each element differs from each other corresponding to the oscillation wavelength to realize equal coupling coefficient. Alternatively, a product of coupling coefficient and the length of area in which the diffraction grating is formed or a product of coupling coefficient and the length of the element is made substantially constant.

## Description

### Field of the Invention

The present invention relates generally to a set of optical semiconductor devices having different wavelengths. More particularly, the present invention relates to a method of manufacturing a set of semiconductor laser elements having different oscillation wavelengths in which variation of coupling coefficients is minimized, so that uniformalization of laser oscillation thresholds, light emission efficiency and long-haul transmission characteristics and an improvement in the yield of single longitudinal mode oscillation can be attained.

### Background of the Invention

In order to cover communication demand which is increasing rapidly in recent years, a wavelength division multiplexing (WDM) optical communications system is progressing in which optical signals having different wavelengths are transmitted in one optical fiber and thereby communications capacity can be greatly increased without newly adding optical fibers. Such WDM optical communications system of course requires a plurality of light sources having different wavelengths. Therefore, there exists a great challenge in how efficiently the light sources having different wavelengths can be realized.

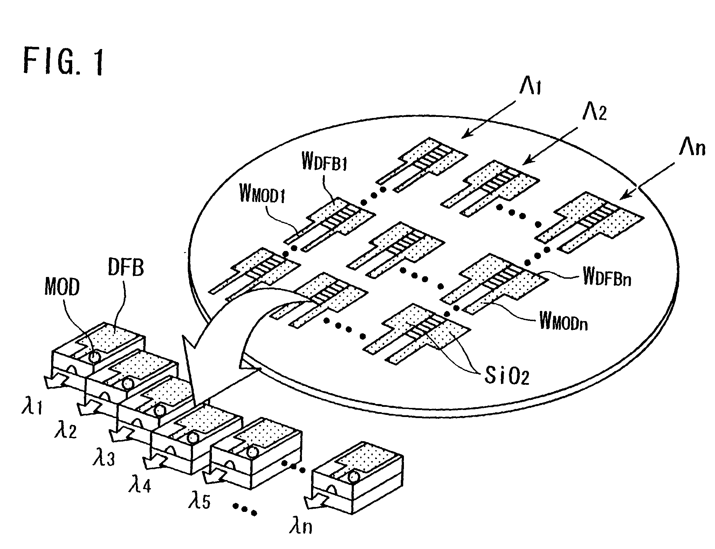

Thus, in Japanese patent laid-open publication No. 10-117040, there is disclosed a method of manufacturing distributed feedback (DFB) lasers having different wavelengths or electro-absorption (EA) modulator integrated DFB lasers having different wavelengths all together from one semiconductor substrate. In order to obtain different wavelengths on one semiconductor substrate, as shown in Fig. 1, after forming diffraction gratings having different periods (pitches: 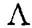 ) by using electron beam exposure and etching technology, multi-layer structures including active layers (optical absorption layers) having bandgap wavelengths corresponding to oscillation wavelengths by using a selective metal-organic vapor phase epitaxy (MOVPE) method.

In this method, since it is possible to make the oscillation wavelengths and the bandgap wavelengths of the laser active layers to coincide with each other within a predetermined range, it is possible to keep the laser oscillation threshold values and uniformity of efficiency in relatively good condition. However, when the active layer (optical absorption layer) is fabricated by the selective MOVPE method, the band gap wavelength of the optical guide layer formed on the diffraction grating varies, and the film thickness of the active layer also varies. When the bandgap wavelength of the guide layer varies, the absolute value of the refractive index on the diffraction grating varies and, therefore, the quantity of variation of periodic variation of the refractive index by the diffraction grating also varies. Also, when the thickness of the active layer varies, the optical confinement factor into the active layer varies and, as a result, intensity of light field in the diffraction grating area also varies. The quantity of variation of the periodic variation of the refractive index by the diffraction grating and light field intensity in the diffraction grating area are parameters which directly relate to the coupling coefficient (κ). Therefore, in the method in which lasers having different wavelengths are fabricated all together but in which these both values vary, the value (κ) varies depending on the oscillation wavelength.

In the technology disclosed in Japanese patent laid-open publication No. 10-117040, the mask width of the mask used in the selective growth is made large to make the oscillation wavelength long. In this case, (1) since the bandgap wavelength of the optical guide layer on the diffraction grating mentioned above also becomes long, the absolute value of the refractive index of the optical guide layer becomes large. (2) Also, since the film thickness of the active layer becomes large, the optical confinement factor into the active layer becomes large and, as a result, the light field intensity in the diffraction grating area is decreased. The effect of item (1) functions to enlarge the coupling coefficient (κ), and the effect of item (2) functions to decrease the coupling coefficient (κ). Therefore, depending on the relation of largeness between both effect, the relationship between the oscillation wavelength (or the mask width of the selective growth) and the coupling coefficient (κ) varies. The relation of largeness between the effect of item (1) and the effect of item (2) depends on an MOVPE apparatus for performing crystal growth or conditions in performing the growth. The coupling coefficient κ is a parameter which closely relates to the oscillation threshold, the light emission efficiency, the oscillation yield of single longitudinal mode, the long-haul transmission characteristics and the like of the DFB laser. If unevenness occurs in the parameter, the yield of element is deteriorated.

A first problem is that there occurs unevenness in the threshold current of the laser oscillation, the efficiency, the oscillation yield of single longitudinal mode.

This is because, the coupling coefficient varies depending on the elements having different oscillation wavelengths.

The second problem is that the yield of transmission characteristic when the long-haul transmission is performed varies depending on the wavelength.

This is because, the coupling coefficient varies depending on the elements and, therefore, the wavelength chirp caused by the residual reflection from the end facet differs depending on the elements.

### Summary of the Invention

Therefore, it is an object of the present invention to obviate the above-mentioned disadvantages of the conventional semiconductor laser elements having different wavelengths.

It is another object of the present invention to suppress variation of coupling coefficient semiconductor laser elements having different wavelengths.

It is still another object of the present invention to suppress variation of a coupling coefficient of a DFB laser portion occurring when a plurality of DFB lasers having different wavelengths or EA modulator integrated DFB lasers having different wavelengths are integrated together on a single semiconductor substrate.

It is still another object of the present invention to uniformalize laser oscillation threshold values, light emission efficiency and long-haul transmission characteristics in a set of semiconductor laser elements having different wavelengths.

It is still another object of the present invention to improve the yield of single longitudinal mode oscillation in a set of semiconductor laser elements having different wavelengths.

According to an aspect of the present invention, there is provided a set of semiconductor laser elements which perform single longitudinal mode oscillation by having periodically varying refractive index within the elements and which are formed together from one semiconductor substrate, the semiconductor laser elements having mutually different oscillation wavelengths, characterized in that each of the semiconductor laser elements comprises a diffraction grating, and a duty cycle of the diffraction grating varies so as to realize equal coupling coefficient.

In this case, it is preferable that the duty cycle of the diffraction grating varies depending on the oscillation wavelength.

It is also preferable that each of the semiconductor laser elements comprises a distributed feedback (DFB) type semiconductor laser and an electro-absorption (EA) type optical modulator formed integrally.

It is further preferable that the duty cycle of the diffraction grating is increased or decreased from 50%.

According to another aspect of the present invention, there is provided a set of semiconductor laser elements which perform single longitudinal mode oscillation by having periodically varying refractive index within the elements and which are formed together from one semiconductor substrate, the semiconductor laser elements having mutually different oscillation wavelengths, characterized in that each of the semiconductor laser elements comprises a diffraction grating, and a product of a coupling coefficient and a length of area in which the diffraction grating is formed in each of the semiconductor laser elements or a product of a coupling coefficient and a length of each of the elements is substantially constant.

In this case, it is preferable that the length of area in which the diffraction grating is formed or the length of the element varies depending on each of the oscillation wavelengths

It is also preferable that each of the semiconductor laser elements comprises a distributed feedback (DFB) type semiconductor laser and an electro-absorption (EA) type optical modulator formed integrally.

According to still another aspect of the present invention, there is provided a method of manufacturing a set of semiconductor laser elements which perform single longitudinal mode oscillation by having periodically varying refractive index within the elements and which are formed together from one semiconductor substrate, the semiconductor laser elements having mutually different oscillation wavelengths, characterized in that the method comprises forming a diffraction grating for each of the semiconductor laser elements such that a duty cycle of the diffraction grating varies to realize equal coupling coefficient.

In this case, it is preferable that the duty cycle of the diffraction grating varies depending on the oscillation wavelengths.

It is also preferable that the duty cycle of the diffraction grating varies depending on a width of a mask for selective growth of a laser element.

It is further preferable that the duty cycle of the diffraction grating varies depending on a location on the semiconductor substrate.

It is advantageous that the forming a diffraction grating for each of the semiconductor laser elements comprises: forming an electron beam sensitive resist film on a semiconductor substrate; patterning the electron beam sensitive resist film by electron beam exposure; and etching the semiconductor substrate by using the patterned electron beam sensitive resist film as a mask to produce the diffraction grating for each of the semiconductor laser elements; wherein the duty cycle of the diffraction grating is changed by changing an electron beam dosage in the electron beam exposure.

It is also advantageous that, in each of the semiconductor laser elements, a distributed feedback (DFB) type semiconductor laser and an electro-absorption (EA) type optical modulator are formed integrally.

According to still another aspect of the present invention, there is provided a method of manufacturing a set of semiconductor laser elements which perform single longitudinal mode oscillation by having periodically varying refractive index within the elements and which are formed together from one semiconductor substrate, the semiconductor laser elements having mutually different oscillation wavelengths, characterized in that the method comprises forming a diffraction grating for each of the semiconductor laser elements, wherein a length of area in which the diffraction grating is formed or a length of the element is adjusted every element such that a product of a coupling coefficient and the length of area in which the diffraction grating is formed in each of the semiconductor laser elements or a product of a coupling coefficient and the length of each of the elements becomes substantially constant.

In this case, it is preferable that the length of area in which the diffraction grating is formed or the length of the element is varied depending on an oscillation wavelength of each laser element.

It is also preferable that the length of area in which the diffraction grating is formed or the length of the element is varied depending on a width of a mask for selective growth of a laser element.

It is further preferable that the length of area in which the diffraction grating is formed or the length of the element is varied depending on a location on the semiconductor substrate.

It is advantageous that, in each of the semiconductor laser elements, a distributed feedback (DFB) type semiconductor laser and an electro-absorption (EA) type optical modulator are formed integrally.

### Brief Description of the Drawings

These and other features, and advantages, of the present invention will be more clearly understood from the following detailed description taken in conjunction with the accompanying drawings, in which like reference numerals designate identical or corresponding parts throughout the figures, and in which:
Fig. 1 is a perspective view showing an example of a conventional structure in which a plurality of laser elements having different wavelengths are formed together on the surface of a single semiconductor substrate;
Fig. 2 is a schematic cross sectional view showing a condition of forming a selective growth layer according to the present invention;
Fig. 3 is a schematic cross sectional view of a DFB laser according to the present invention in a longitudinal direction of a waveguide;
Fig. 4A and Fig. 4B are graphs showing relationships between mask width and photoluminescence wavelength;
Fig. 5 is a graph showing relationships between the height of diffraction grating and coupling coefficient (κ);
Fig. 6 is a graph showing relationships between the DFB oscillation wavelength and coupling coefficient;
Fig. 7 is a graph showing a relationship between a distance from the center of the substrate and a normalized growth rate in an InGaAsP/InGaAsP multi quantum well structure;
Fig. 8 is a graph showing relationships between a distance from the center of the substrate and a photoluminescence wavelength in an InGaAsP/InGaAsP multi quantum well structure;
Fig. 9 is a graph showing a relationship between the DFB oscillation wavelength and coupling coefficient;
Fig. 10 is a graph showing relationships between coupling coefficient and power penalty and between coupling coefficient and yield of single mode oscillation;
Fig. 11 is a graph showing relationships between product of coupling coefficient multiplied by DFB laser resonator length (κ L) and power penalty and between the product and yield of single mode oscillation;
Fig. 12 is a graph showing relationships between duty cycle of diffraction grating and coupling coefficient;
Fig. 13 is a graph showing relationships between duty cycle of diffraction grating and κL;
Fig. 14 is a graph showing relationships between DFB laser resonator length (L) and κL;
Fig. 15A through Fig. 15D are schematic cross sectional views showing as an example a technique for forming a diffraction grating according to a method of the present invention;
Fig. 16 is a schematic cross sectional view showing as an example a diffraction grating fabricated by the method illustrated in Fig. 15;
Fig. 17 is a graph showing a relationship between electron dosage and duty cycle of diffraction grating;
Fig. 18A and Fig. 18B are perspective views showing an example of a method for forming a diffraction grating;
Fig. 19 is a schematic view showing a planar arrangement of a plurality of partial diffraction gratings;
Fig. 20 is a graph showing a relationship between the DFB oscillation wavelength and pitch (Λ) of diffraction grating;
Fig. 21A is a graph showing a relationship between DFB oscillation wavelength and duty cycle of diffraction grating;
Fig. 21B is a graph showing a relationship between mask width and duty cycle of diffraction grating;
Fig. 22 is a perspective view showing a relationship between a plurality of partial diffraction gratings and SiO₂ stripe masks;
Fig. 23 is a perspective view showing a relationship between a single partial diffraction grating and SiO₂ stripe masks;
Fig. 24 is a graph showing relationships between DFB oscillation wavelength and mask width (W_{LD} or W_{MOD});
Fig. 25 is a perspective view showing a condition in which a guide layer, a strained MQW layer and a p-InP layer are formed in the structure of Fig. 23;
Fig. 26 is a cross sectional taken along line A-A' of Fig. 25;
Fig. 27A through Fig. 27C are schematic cross sectional views showing, as an example, sequentially performed techniques for forming a p-InP cladding layer and a p⁺-InGaAs cap layer in the structure of Fig. 25;
Fig. 28 is a perspective view showing a condition after forming an SiO₂ layer and a p-electrode, and performing back surface polishing;
Fig. 29 is a graph showing relationships between a plurality of channels and the DFB oscillation wavelengths;
Fig. 30 is a graph showing a relationship between the DFB oscillation wavelengths and coupling coefficients;
Fig. 31 is a graph showing relationships between DFB oscillation wavelengths and yield of transmission and between DFB oscillation wavelengths and yield of single mode oscillation;
Fig. 32 is a schematic view showing a planar arrangement of a plurality of diffraction gratings;
Fig. 33 is a perspective view showing a relationship between a plurality of diffraction gratings and SiO₂ stripe masks;
Fig. 34 is a perspective view showing a relationship between a single partial diffraction grating and SiO₂ stripe masks for a single device;
Fig. 35A through Fig. 35E are schematic cross sectional views showing, as an example, sequentially performed techniques for forming a plurality of layers on the structure of Fig. 34 by a MOVPE growth method, and each corresponds to a cross sectional view taken along line D-D' of Fig. 34;
Fig. 36 is a perspective view showing a condition after performing patterning of a p-electrode and back surface polishing in the structure of Fig. 35;
Fig. 37 is a graph showing a relationship between the DFB oscillation wavelengths and coupling coefficients;
Fig. 38 is a graph showing relationships between DFB oscillation wavelengths and yield of single mode oscillation;
Fig. 39A is a graph showing a relationship between DFB oscillation wavelengths and duty cycles of diffraction gratings;
Fig. 39B is a graph showing a relationship between a distance from the center of the substrate and duty cycles of diffraction gratings;
Fig. 40 is a graph showing relationships between a plurality of channels and the DFB oscillation wavelengths;
Fig. 41 is a graph showing a relationship between the DFB oscillation wavelengths and coupling coefficients;
Fig. 42 is a graph showing relationships between DFB oscillation wavelengths and yield of transmission and between DFB oscillation wavelengths and yield of single mode oscillation;
Fig. 43 is a schematic view showing a planar arrangement of a plurality of partial diffraction gratings;
Fig. 44A is a graph showing a relationship between length of area where diffraction grating is formed and mask width;
Fig. 44B is a graph showing a relationship between DFB oscillation wavelengths and the length of area where diffraction grating is formed;
Fig. 45 is a perspective view showing a relationship between a partial diffraction grating and SiO₂ stripe masks for a single device;
Fig. 46 is a perspective view showing a condition in which a guide layer, a strained MQW layer and a p-InP layer are formed in the structure of Fig. 45;
Fig. 47 is a graph showing a relationship between the DFB oscillation wavelengths and product of coupling coefficient and length of grating region (κ L); and
Fig. 48 is a graph showing relationships between DFB oscillation wavelengths and yield of transmission and between DFB oscillation wavelengths and yield of single mode oscillation.

### Description of a Preferred Embodiment

The present invention will now be described in detail below.

According to an analysis by the inventor of this invention, it has been found that a coupling coefficient (κ), which increases and decreases depending on the oscillation wavelength, varies depending on the duty cycle of each diffraction grating of the element having the coupling coefficient. Here, the duty cycle of a diffraction grating is defined as [{L_{M}/(L_{M}+L_{C})} × 100] (%), where L_{M} is a width of a peak and L_{C} is a width of a valley of the diffraction grating. As will be mentioned later, the coupling coefficient becomes maximum when the duty cycle of the diffraction grating is 50 %, and becomes small as the duty cycle of the diffraction grating departs from this value. Therefore, when the coupling coefficient increases due to the increase and decrease of the oscillation wavelength, it is possible to maintain the coupling coefficient approximately constant by mitigating the increase in the coupling coefficient by increasing or decreasing the duty cycle of the diffraction grating from the 50 percent value. Thereby, it becomes possible to uniformalize laser oscillation threshold values, light emission efficiency and long-haul transmission characteristics and to improve the yield of single longitudinal mode oscillation mentioned above.

The above-mentioned explanation on the coupling coefficient which affects the yield of single longitudinal mode oscillation and the like concerns the case in which the length of an area where the diffraction grating is formed or the length of the element is constant. However, in practice, it is possible to avoid the disadvantage caused by the increase and decrease of the oscillation wavelength, by keeping the product of the coupling coefficient and the length of the area where the diffraction grating is formed or the length of the element substantially constant. That is, it is possible to decrease or increase the length of the area where the diffraction grating is formed or the length of the element, in accordance with the increase or decrease of the coupling coefficient.

Next, with reference to the drawings and a prior art method, an explanation will be made on a method of manufacturing an optical semiconductor device according to the present invention.

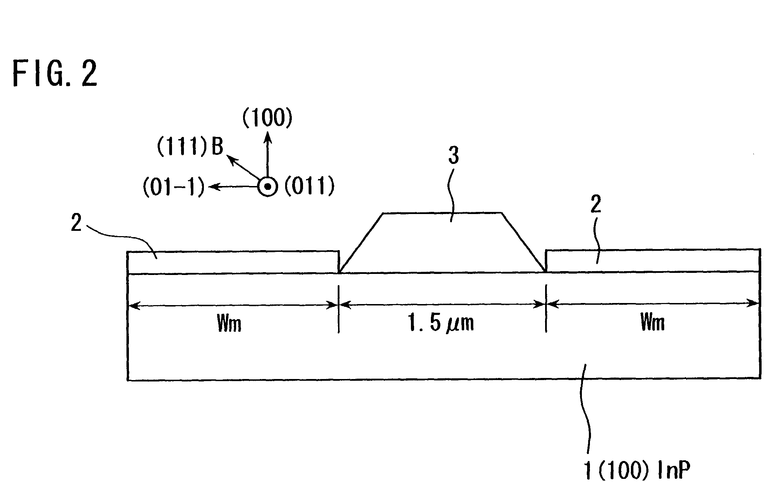

Fig. 2 is a schematic cross sectional view of a wafer having an InGaAsP selective growth layer which is grown by the selective MOVPE method. By selectively growing an InGaAsP layer 3 by the MOVPE method by using a pair of SiO₂ stripe masks 2 which are formed in the direction [011] on a (100)InP substrate 1 and which have a space of 1.5 µm, an InGaAsP crystal grows into a trapezoid form whose side surface is the (111)B plane and whose top surface is the (100) plane. Also, it is known that when the mask width Wm is increased, the growth rate (film thickness) becomes large and indium composition increases due to the flow of raw material from top portions of the mask. By using this phenomenon, it is possible to form layer structures having different bandgap wavelengths within the same substrate surface.

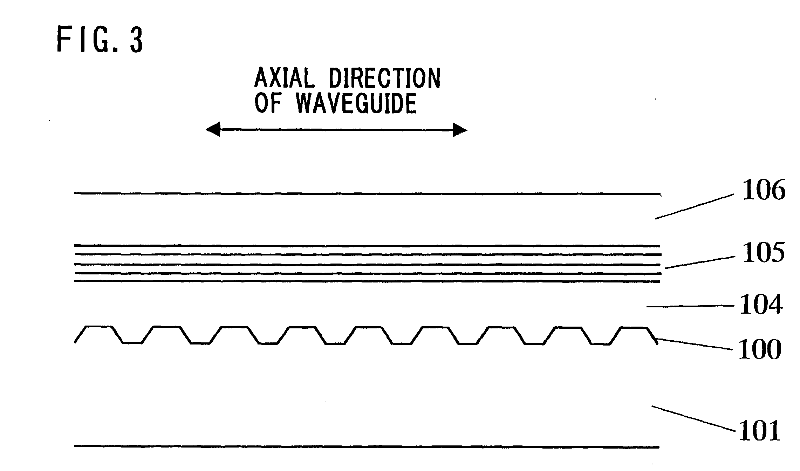

Fig. 3 is a schematic cross sectional view in the axial direction of a waveguide of a DFB laser. Fig. 3 shows a typical DFB laser layer structure in which a diffraction grating 100 is formed on an InP substrate 101, and, on the diffraction grating 100, an InGaAsP guide layer 104, a multi-quantum well (MQW) active layer 105 and an InP clad 106 are sequentially stacked. Generally, in case of a 1.55 µm band DFB laser, composition having a bandgap wavelength of 1.0 through 1.3 µm is preferably used in the InGaAsP guide layer 104.

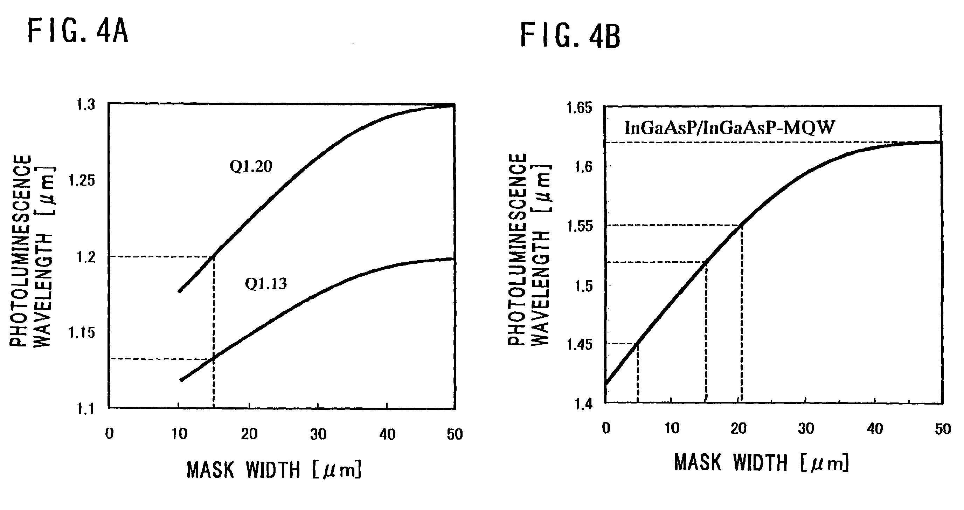

Fig. 4A shows relationships between photoluminescence wavelengths and mask widths (10-50 µm), when an InGaAsP [bandgap wavelengths 1.13 µm (Q1.13) and 1.20 µm (Q1.20)] as a guide layer on the diffraction grating of the 1.55 µm band DFB laser is grown by selective MOVPE method so as to lattice match to the InP substrate and in a condition the mask width is preferably 15 µm. In case the bandgap wavelength is 1.13 µm, when the mask width is increased to 50 µm, the photoluminescence wavelength increases up to 1.20 µm in length. This is because, the indium component increases due to an increase in the mask width and compressive strain is introduced.

Fig. 4B shows an example of a relationship between photoluminescence wavelengths and mask widths (0-50 µm), when an InGaAsP/InGaAsP MQW structure is grown by selective MOVPE method. In this case, it can be seen that, by increasing the mask width from 15 µm to 50 µm, it is possible to cover the wavelength range from 1.52 µm to 1.62 µm. also, when the mask width is set from 5 µm to 21 µm, it is possible to cover the wavelength range from 1.45 µm to 1.55 µm, which can be operating wavelengths of electro-absorption (EA) type modulators for the DFB lasers having wavelengths from 1.52 µm to 1.62 µm.

In this case, there occurs a problem on the coupling coefficients (κ) in different oscillation wavelengths. When the DFB lasers having different wavelengths from 1.52 µm to 1.62 µm are fabricated by changing the mask width from 15 µm to 50 µm, the bandgap wavelength of the guide layer also varies from 1.13 µm to 1.20 µm. In this case, an InGaAsP layer, in which a bandgap wavelength becomes 1.13 µm when the mask width is 15 µm, is used as the guide layer on the diffraction grating. The variation of the bandgap wavelength of the guide layer means that the refractive index of the guide layer also varies. Therefore, due to the existence of the diffraction grating, the coupling coefficient (κ) is also changed which is caused by the periodic variation of the refractive index.

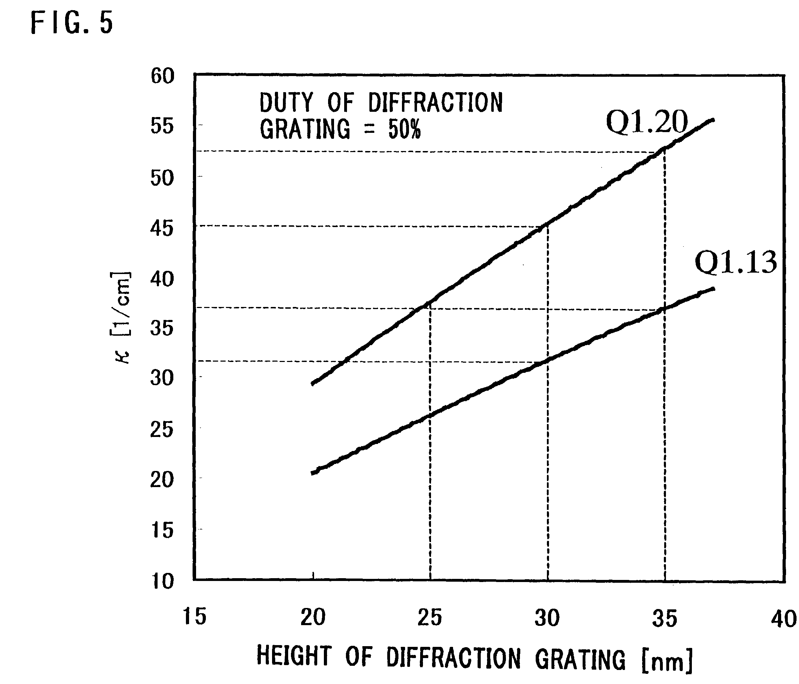

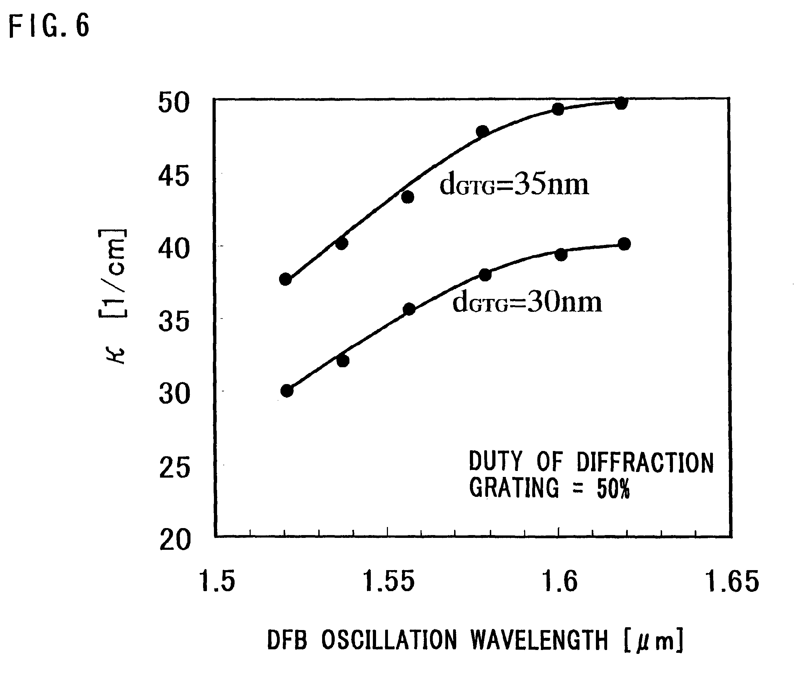

Fig. 5 shows relationships between a height of the diffraction grating, which is proportional to the quantity of variation of the periodic variation in the refractive index, and the κ, obtained as a result of calculation by using guide layer composition as a parameter. In the calculation, it is assumed that the duty cycle of the diffraction grating (ratio of the peak and the valley of the diffraction grating) is 50 percent. Assuming that the height of the diffraction grating is 35nm, when the bandgap wavelength of the guide layer varies from 1.13 µm to 1.20 µm, it is expected that the κ changes from 37.5 to 53cm⁻¹. DFB lasers having oscillation wavelengths from 1.52 to 1.62 µm are actually formed together. Fig. 6 shows a result obtained by measuring the relationships between the κ and the oscillation wavelengths in such DFB lasers. In this experiment, consideration was made on two kinds of heights of the diffraction gratings (d_{GTG}), that is, 30nm and 35nm. As a result of this experiment, it is confirmed that the κ varies from 30 to 40 cm⁻¹ when the height of the diffraction grating is 30nm, and varies from 38 to 50 cm⁻¹ when the height of the diffraction grating is 35nm. In each of both cases, the quantity of variation is slightly smaller than the calculated value shown in Fig. 5. This is because, in the calculation of Fig. 5, consideration was not made on an increase in the optical confinement factor into the active layer due to an increase in the film thickness caused by an increase in the mask width.

Next, an explanation will be made on a method of forming the laser active layers having different bandgaps together within the surface of the semiconductor substrate, without changing the mask width in the selective MOVPE method.

In a vertical MOVPE apparatus, when a carrier gas flow rate is larger than that corresponding to the condition in which the uniformity of the grown film thickness within a surface becomes best, it is possible to increase the growth rate from the central portion of the substrate to the peripheral portion of the substrate (to deteriorate the uniformity). Similarly, in a lateral MOVPE apparatus, when a carrier gas flow rate is larger than that corresponding to the optimum condition for the uniformity of the grown film thickness, it is possible to realize a distribution in which the growth rate increases from the upper side to the lower side of the gas flow. On the contrary, when the MOVPE growth is performed at a carrier gas flow rate smaller than that corresponding to the condition in which the uniformity of the grown film thickness becomes best, it is possible to realize a distribution of the film thickness within a surface which is opposite to that in the condition the carrier gas flow rate is larger than that corresponding to the optimum condition for the uniformity.

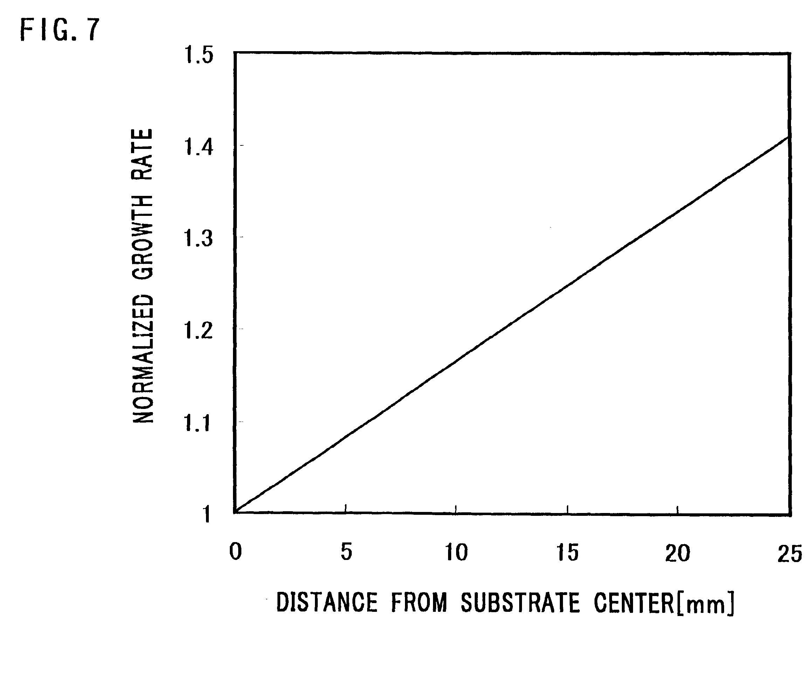

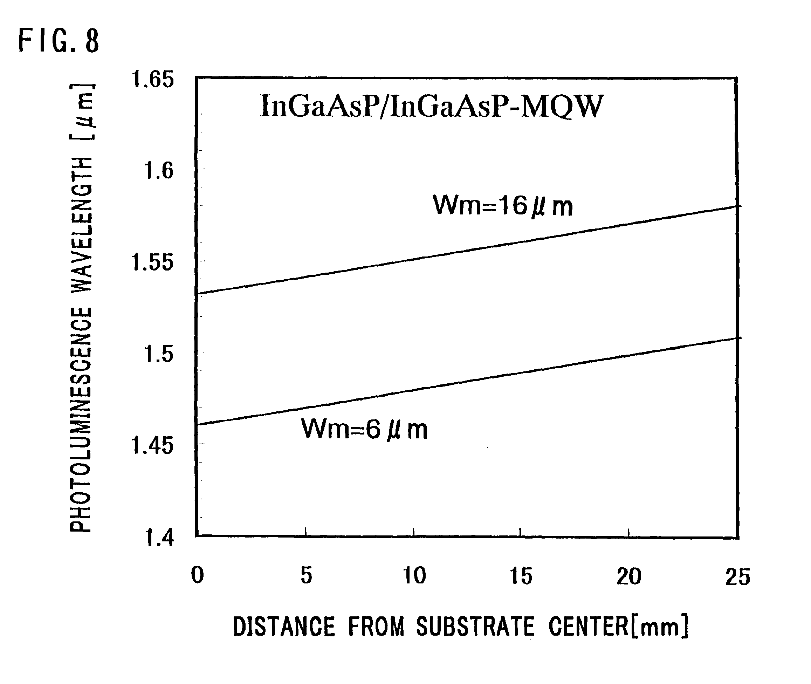

Fig. 7 shows a normalized growth rates as a function of a distance from the center of a substrate in case the growth rate at the central portion of a 2-inch InP substrate is considered to be 1, and shows an example in which the carrier gas flow rate is set to 1.5 times the optimum condition for the uniformity, in the vertical MOVPE apparatus. It can be seen that the growth rate at the outermost periphery of the substrate is approximately 1.4 times the growth rate at the central portion of the substrate. By using this distribution of the film thickness within the surface, an InGaAsP/InGaAsP multi-quantum well structure was selectively grown. Fig. 8 shows a result of measurement of surface distributions of photoluminescence (PL) wavelengths thereof.

The mask pattern used for the selective growth is the same as that shown in Fig. 2. Fig. 8 shows the distributions for two cases, that is, the case in which the mask width (Wm) is 6 µm and the case in which the mask width is 16 µm. As a result, in case Wm=6 µm, it is possible to obtain a PL wavelength distribution from 1.46 µm (1460nm) to 1.51 µm (1510nm) within a substrate plane, and, in case Wm=16 µm, it is possible to obtain a PL wavelength distribution from 1.53 µm (1530nm) to 1.58 µm (1580nm) within a substrate plane. By utilizing these distributions, it is possible to form the DFB lasers having different wavelengths together on one semiconductor substrate. In this case, by setting the mask width at 16 µm, it is possible to realize the DFB lasers having a wavelength range from 1.53 µm to 1.58 µm, and, by setting the mask width at 6 µm, it is possible to realize a wavelength range from 1.46 µm to 1.51 µm, so that it is possible to obtain operation wavelengths of electro-absorption (EA) type modulator for the DFB lasers having a wavelength range from 1.53 µm to 1.58 µm.

In this case, there occurs a problem on the coupling coefficients (κ) in different oscillation wavelengths. The thickness of the MQW active layers of the DFB lasers having different wavelengths in a range from 1.53 µm to 1.58 µm varies 1.4 times at maximum. Therefore, the optical confinement factor into the MQW active layer becomes larger as the thickness of the layer becomes larger in an element having longer wavelength, so that optical field in the diffraction grating portion becomes weaker. As a result, the κ becomes smaller in an element having a longer wavelength.

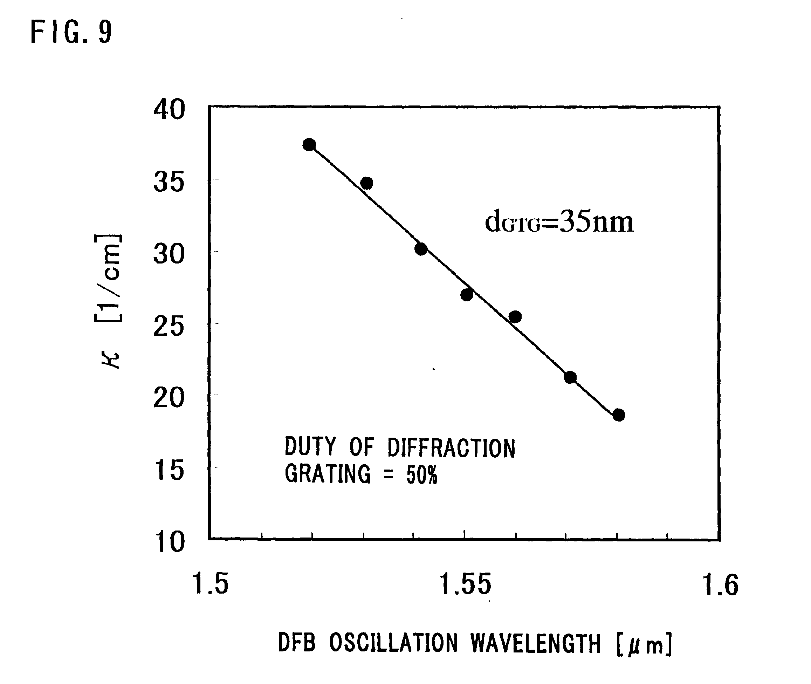

The DFB lasers having different wavelengths were actually formed together, and the κ was measured. Fig. 9 shows a result of the actual measurement of the κ. In the DFB lasers actually fabricated, the depth of the diffraction grating was 35nm, and the duty cycle of the diffraction grating was 50 percent. As the oscillation wavelength becomes long, the κ decreases monotonously, and it was confirmed that the κ of the element having an oscillation wavelength 1.58 µm decreases approximately to a half of that of an element having an oscillation wavelength 1.53 µm.

In addition to the variation of the laser oscillation threshold and the efficiency, the variation of the κ causes problems of deterioration of the yield of single longitudinal mode oscillation and deterioration of long-haul transmission characteristic. Especially, the long-haul transmission characteristic is very important, because it is an item of final evaluation after fabricating the elements. A factor that the κ affects the deterioration of the long-haul transmission characteristic is caused by a wavelength chirp induced by reflected return light in a modulation operation. Therefore, in order to enlarge the reflection immunity to suppress the wavelength chirp, it is preferable that the κ is made as large as possible.

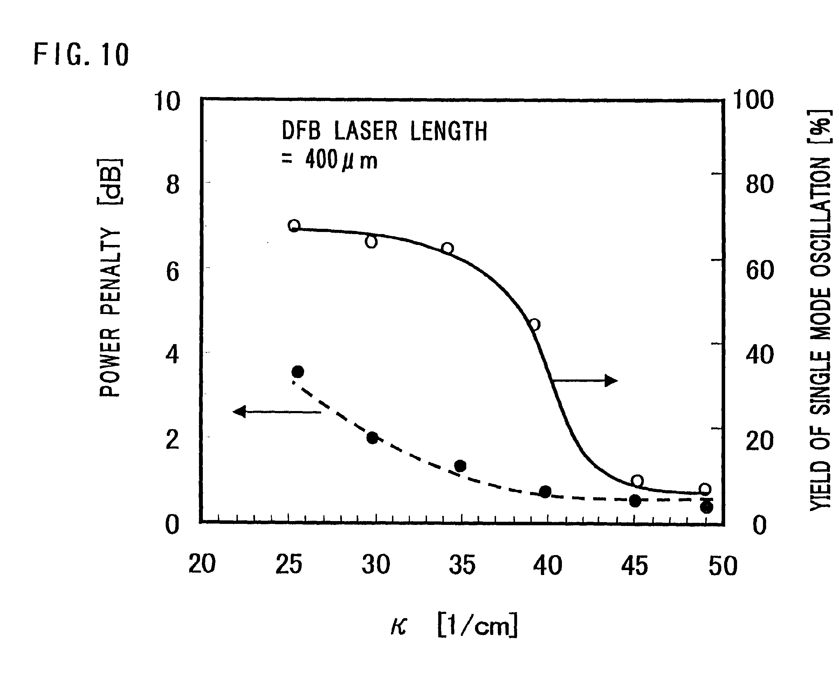

Fig. 10 shows a relationship between the κ and power penalty (shown by a dotted line and ●), and a relationship between the κ and yield of single longitudinal mode oscillation (shown by a solid line and ○), with 2.5Gb/s modulation and after the transmission of 600km. The element used for the measurement comprises a uniform diffraction grating type DFB laser having 400 µm in length, and an EA modulator having 200 µm in length, which are monolithically integrated.

The power penalty after the transmission of 600km becomes smaller as the κ becomes larger, and when κ > 37cm⁻¹, the power penalty equal to or smaller than 1dB is realized. On the other hand, when the κ becomes large, the yield of single longitudinal mode oscillation is deteriorated due to the influence of the spatial hole burning effect. Therefore, it becomes very important to control the κ within a predetermined range.

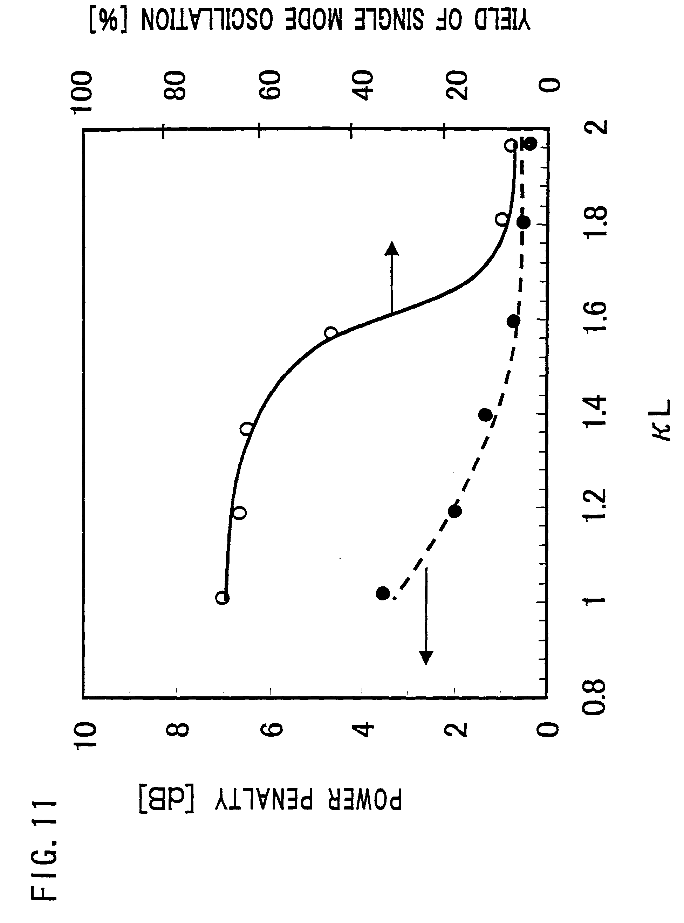

Fig. 11 shows similar relationships as functions of the products (κL) of the coupling coefficient and the length (L) of the DFB laser resonator. From Fig. 11, it can be seen that, in order to realize the power penalty equal to or smaller than 1dB, it is necessary that the κL is equal to or larger than 1.5.

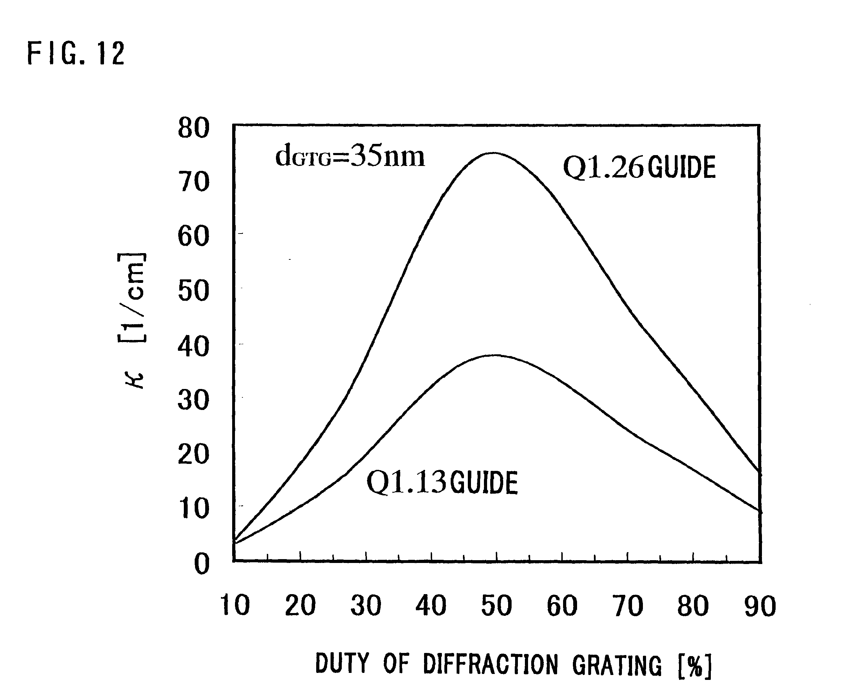

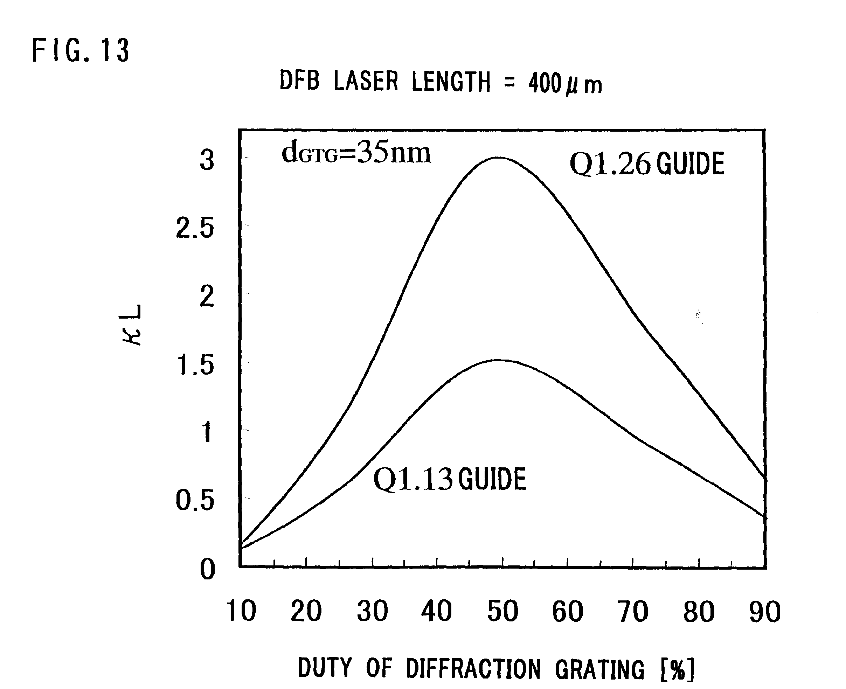

In case the bandgap wavelength of the guide layer or the film thickness of the MQW active layer does not vary, it is possible to change the κ by changing the duty cycle of the diffraction grating. Fig. 12 and Fig. 13 show a relationship between the duty cycle of the diffraction grating and the κ and a relationship between the duty cycle of the diffraction grating and the κ L, respectively. It can be seen that each of the κ and the κ L becomes maximum when the duty cycle of the diffraction grating is 50 percent (when the ratio between the peak width and the valley width is 1:1). This is because, the quantity of variation of refractive index which varies due to the existence of the diffraction grating becomes maximum when the duty cycle of the diffraction grating is 50 percent.

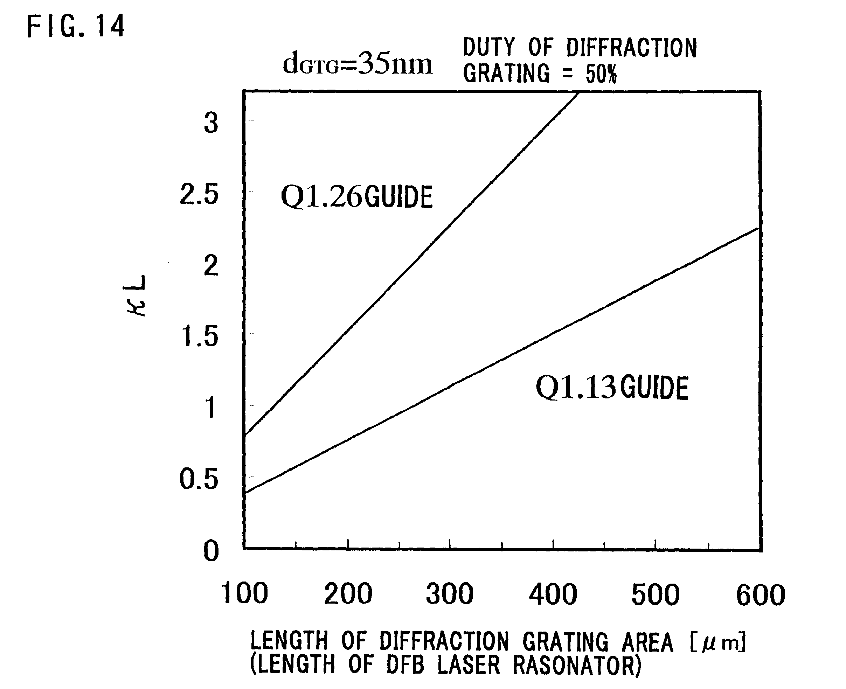

According to a first characteristic feature of the present invention, there is provided a method in which the κ is kept constant by modulating the duty cycle of the diffraction grating. According to the prior art manufacturing method, the κ varies depending on the oscillation wavelength. Also, as shown in Fig. 14, when the κ is constant, the κL is proportional to the length L of the area where the diffraction grating is formed (the length of the laser resonator). Therefore, by adjusting the length L of the area where the diffraction grating is formed so as to cancel the variation of the κ, it is possible to keep the value of the κL constant. This is the second characteristic feature of the present invention.

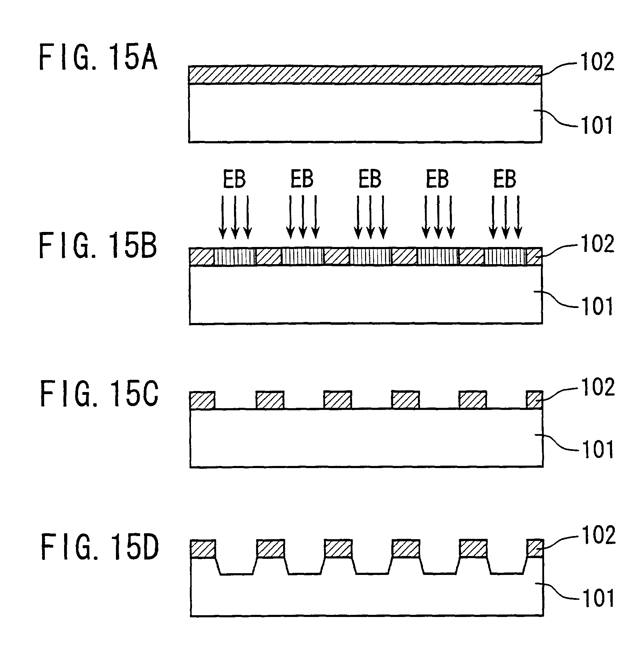

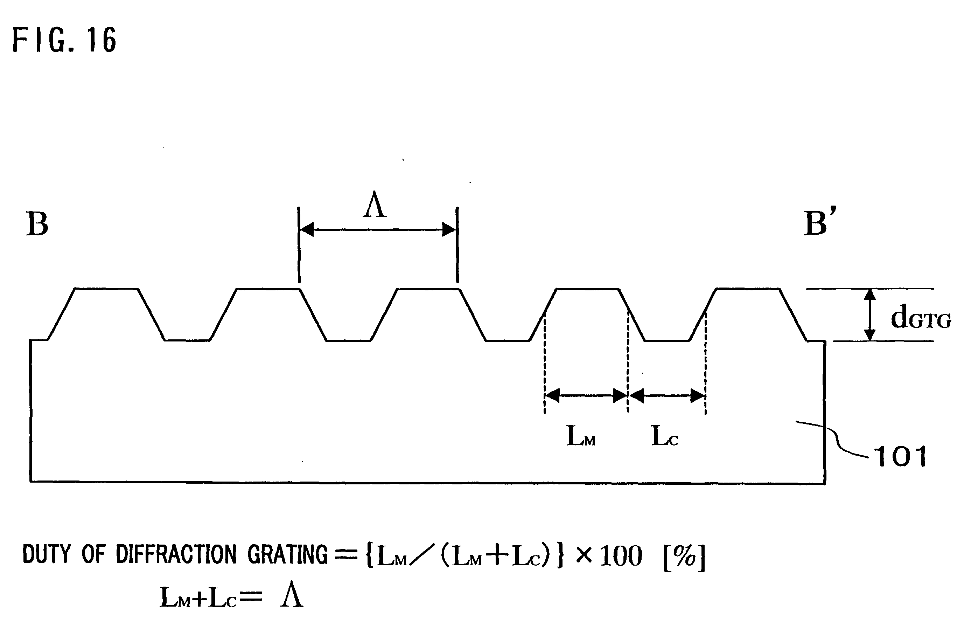

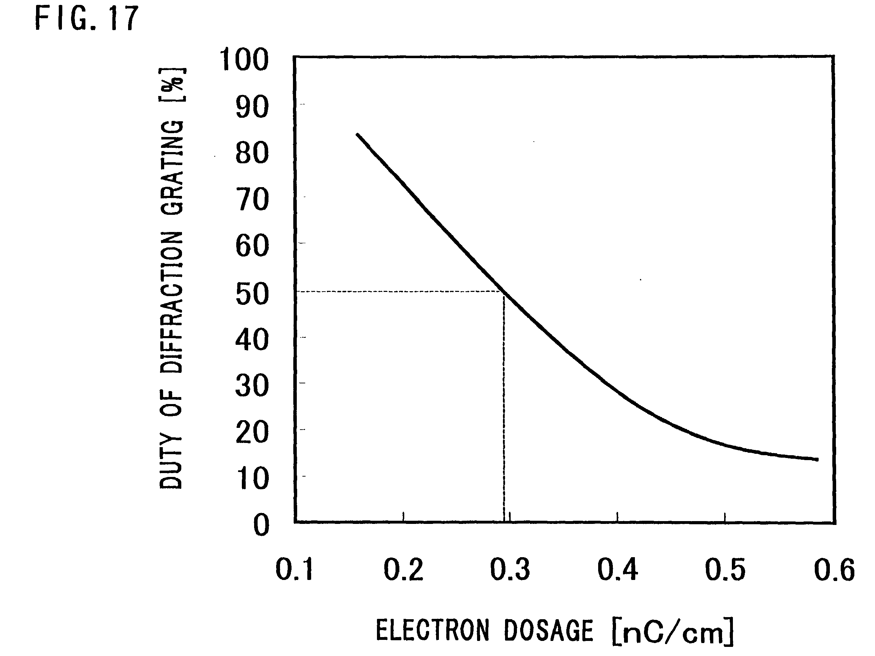

With reference to Figs. 15A through 15D and Fig. 16, an explanation will now be made on a method of modulating the duty cycle of the diffraction grating. As shown in Fig. 15A, an electron beam exposure resist layer 102 is applied onto an InP substrate 101. Thereafter, an electron beam is irradiated at a period of the diffraction grating as shown in Fig. 15B and developed as shown in Fig. 15C. Then, opening portions of the resist are etched by chemical etching which uses etchant of HBr:H₂O₂ system to form a diffraction grating structure as shown in Fig. 15D. When the resist portions are removed, the diffraction grating as shown in Fig. 16 is fabricated. Here, the duty cycle of a diffraction grating is defined as [{L_{M}/L_{M}+L_{C})} × 100] (%), where L_{M} is a width of a peak and L_{C} is a width of a valley of the diffraction grating. In order to adjust the duty cycle of the diffraction grating, it is possible to change quantity of irradiation of the electron beam in the process illustrated in Fig. 15B. Fig. 17 shows a relationship between the quantity of irradiation of the electron beam (electron dosage) and duty cycle of the diffraction grating obtained by experiment. As apparent from the drawing, when the electron dosage is increased, each exposure area in Fig. 15B becomes wide and, therefore, each area etched in Fig. 15D becomes large. As a result, the width of each mountain portion of the diffraction grating becomes smaller so that the duty cycle of the diffraction grating is decreased. By using this phenomenon, it becomes possible to control the duty cycle of the diffraction grating, by the electron dosage at the electron beam exposure.

With reference to the drawings, a concrete example of a manufacturing method of a set of semiconductor laser elements according to the present invention will now be described in further detail.

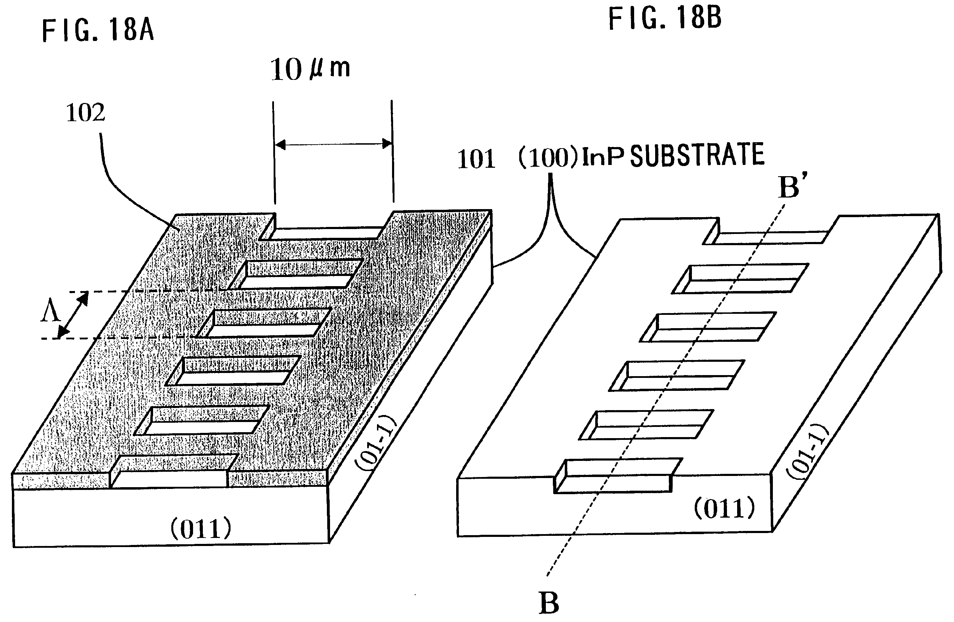

With reference to Figs. 18A and 18B, an explanation will be made on a method of manufacturing an integrated EA modulator type DFB lasers having different wavelengths according to the first embodiment.

As shown in the drawing, positive resist 102 having electron beam sensitivity is applied on a (100)n-InP substrate 101. Then, patterns shown in Fig. 18A are written by an electron beam exposure method. Thereafter, the n-InP substrate 101 is etched by using the resist 102 as a mask and by using etching solution of HBr:H₂O₂ system. Thereby, a diffraction grating as shown in Fig. 18B is fabricated. Fig. 16 corresponds to a cross sectional view taken along a line B-B' of Fig. 18B.

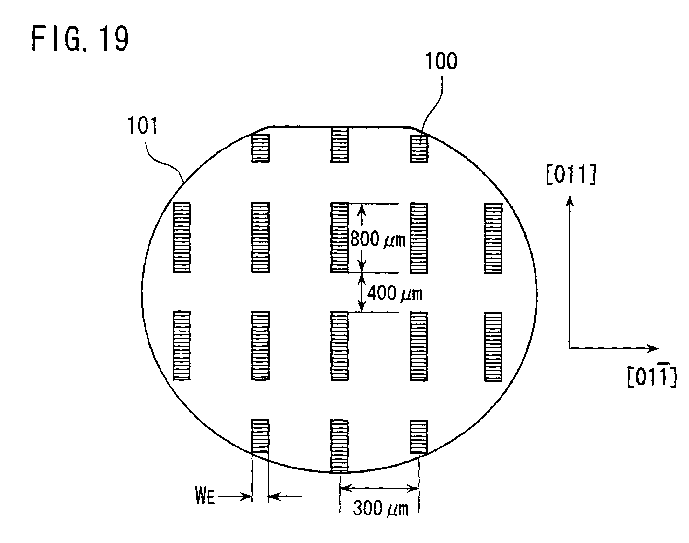

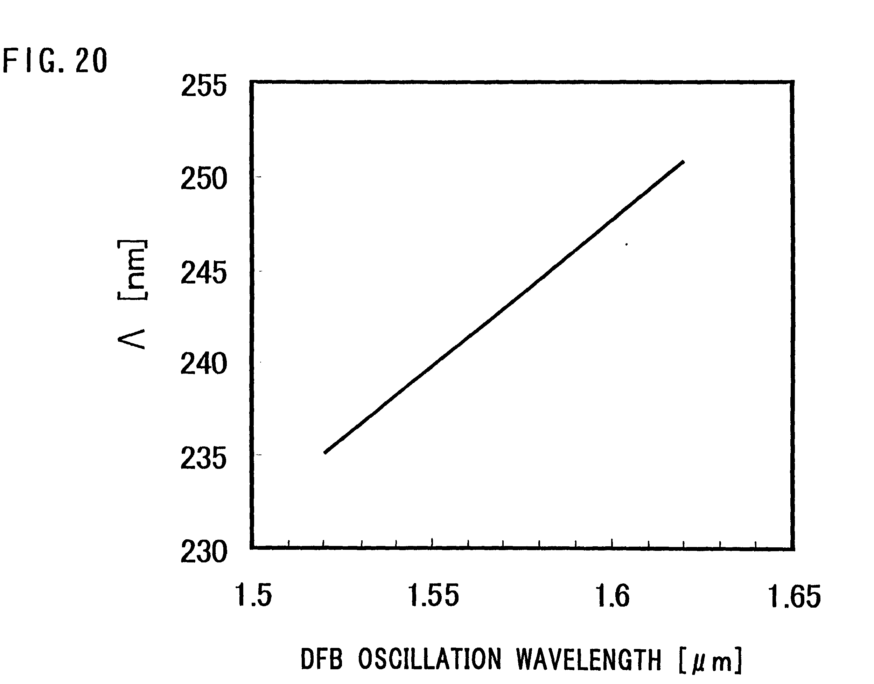

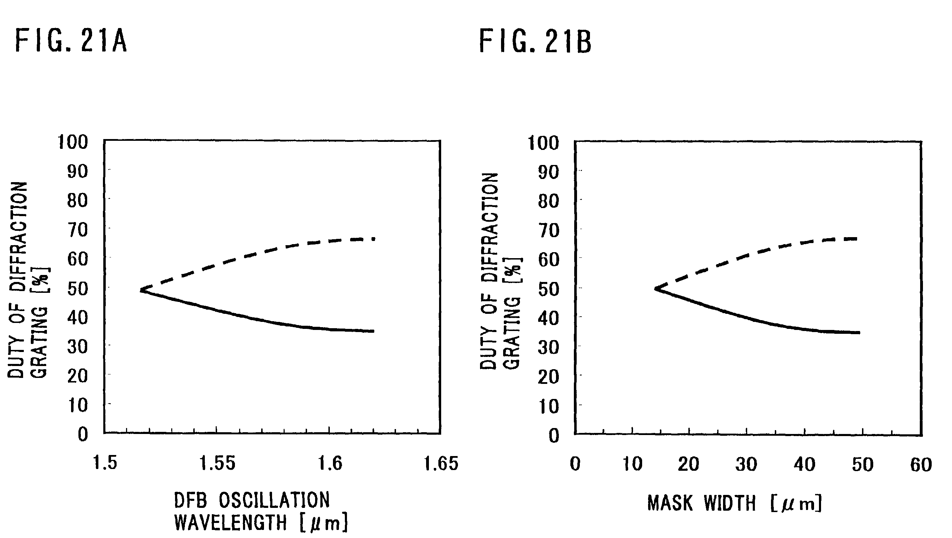

As shown in Fig. 19, the diffraction gratings are formed in patterns in which diffraction grating formed areas each having 800 µm in length and unformed areas each having 400 µm in length between the diffraction gratings are repeated in [011] direction, and in patterns in which diffraction gratings are repeatedly formed at a pitch of 300 µm in [01-1] direction. When realizing the EA modulator integrated type DFB lasers, in order to control oscillation wavelengths of the DFB lasers, pitches 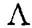 of the diffraction gratings were changed from 235.05 to 250.85nm as shown in Fig. 20, and, by changing electron dosage, the duty cycles of the diffraction gratings were changed in a range from 50% to 35%, or from 50% to 67%, as shown in Figs. 21A and 21B, according to the oscillation wavelength of the DFB laser, or the mask width in the selective growth as described below.

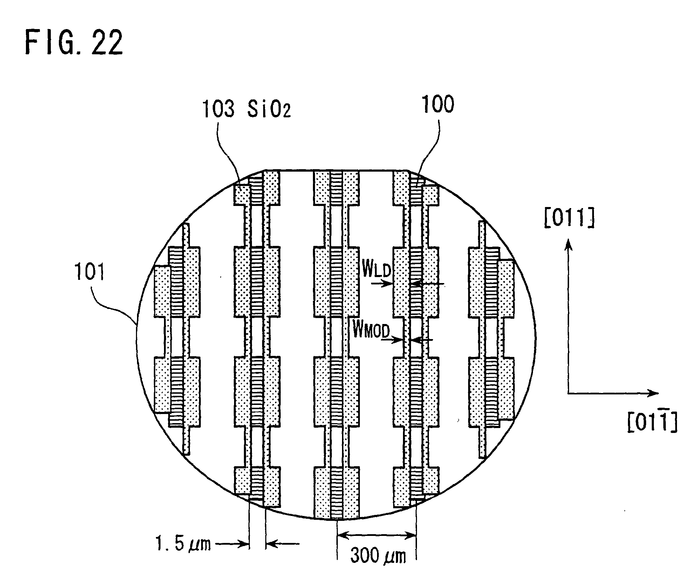

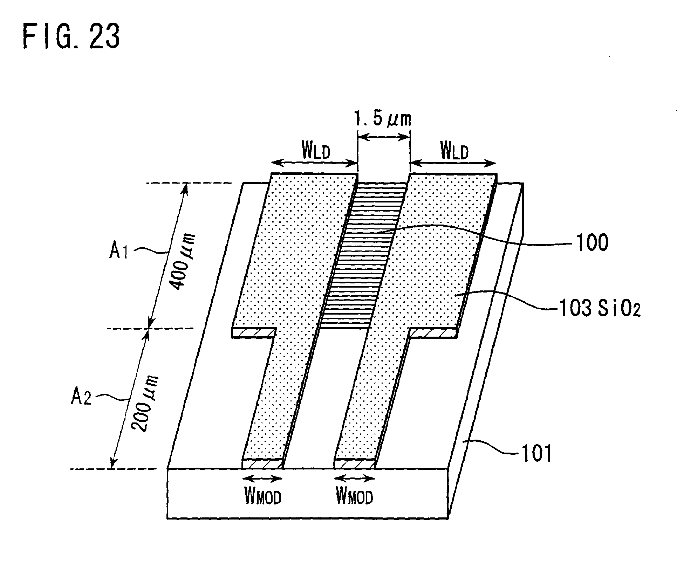

Next, as shown in Fig. 22, a pair of SiO₂ stripe masks 103 for the selective MOVPE growth are patterned so as to synchronize with the diffraction gratings 100. Mask widths were set to W_{LD} in each area where the diffraction grating was formed, and to W_{MOD} in each area where the diffraction grating was not formed. Fig. 23 represents the SiO₂ mask patterns for only one element. That is, an area A1 having the mask width W_{LD} (having a length of 400 µm) corresponds to a portion which becomes a DFB laser, and an area A2 having the mask width W_{MOD} (having a length of 200 µm) corresponds to a portion which becomes an EA modulator. In this structure, the space between a pair of stripe masks had a fixed value of 1.5 µm.

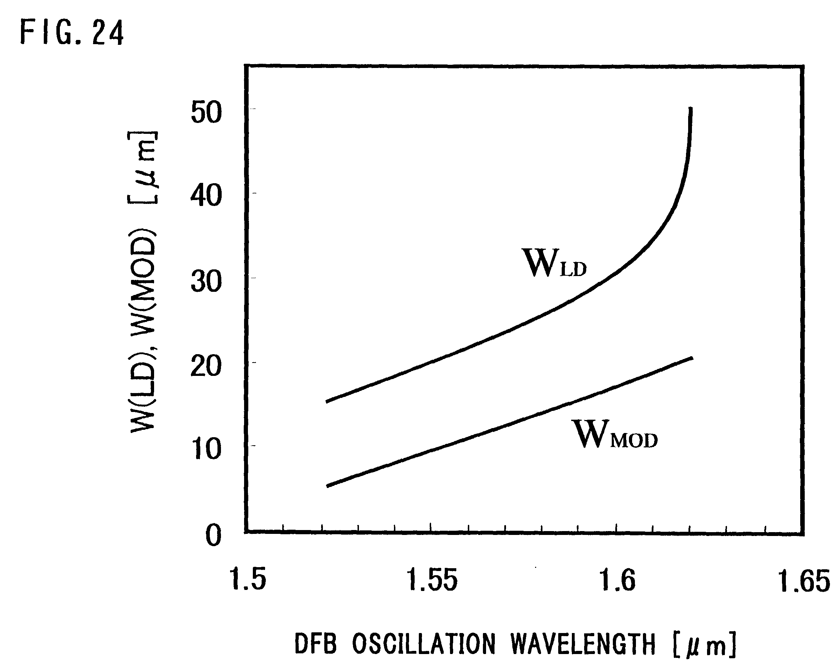

Fig. 24 shows design values for W_{LD} and W_{MOD} with respect to the DFB oscillation wavelengths. Fig. 20, Figs. 21A and 21B and Fig. 24 show the pitches Λ of the diffraction gratings, the duty cycles of the diffraction gratings, W_{LD} and W_{MOD}, respectively, as continuous values with respect to the DFB oscillation wavelengths. However, in practice, the values in the graphs of Fig. 20, Figs. 21A and 21B and Fig. 24 have discontinuous values having 125 steps. This is because, in the present embodiment, a range of the DFB oscillation wavelengths from 1.52 to 1.62 µm is divided into 125 kinds of wavelengths having a space of 100GHz (approximately, a space of 0.8nm) therebetween.

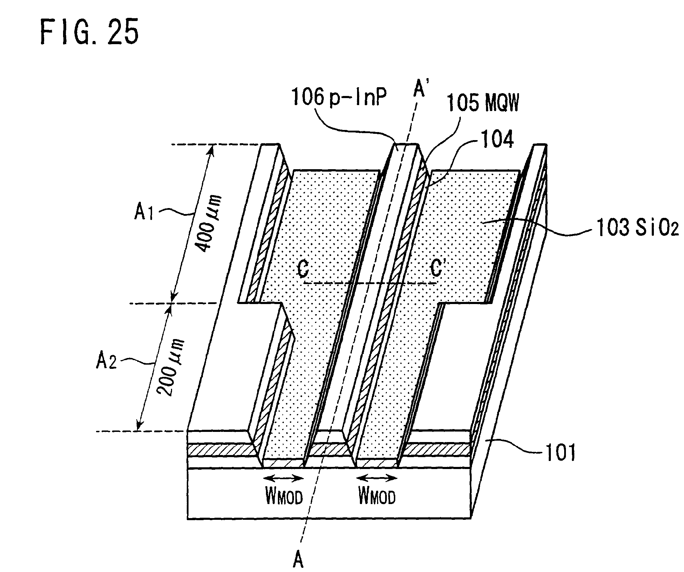

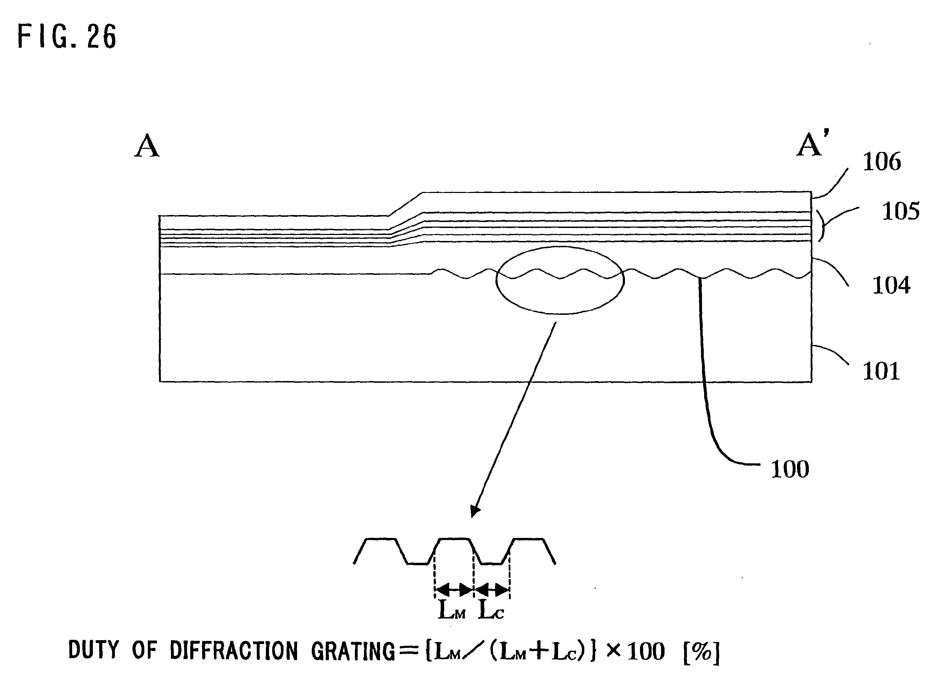

By using the substrate having the SiO₂ patterns mentioned above, a laser active layer and a modulator absorption layer were grown thereon by the selective MOVPE growth, as shown in Fig. 25. Selective growth layers included an n-InGaAsP guide layer (having bandgap wavelength of 1.13 µm, film thickness of 150nm, n=1 × 10¹⁸cm⁻³) 104, a strained MQW layer (8 cycles of well layers: InGaAsP (strain of +0.60%, thickness of 10nm), and barrier layers: InGaAsP (having bandgap wavelength of 1.20 µm, thickness of 9nm)) 105, and p-InP layer (having a thickness of 150nm, p=5 × 10¹⁷cm⁻³) 106, where all these values are values at W_{LD}=15 µm. Fig. 26 is a cross sectional view taken along line A-A' of Fig. 25, and shows a structure in which a diffraction grating exists in an area of a DFB laser.

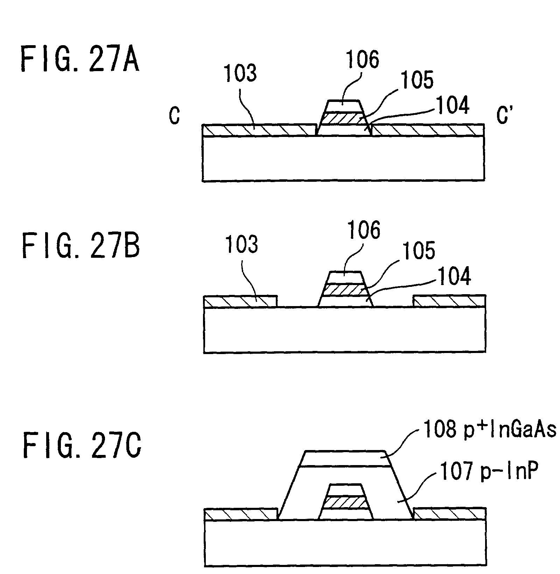

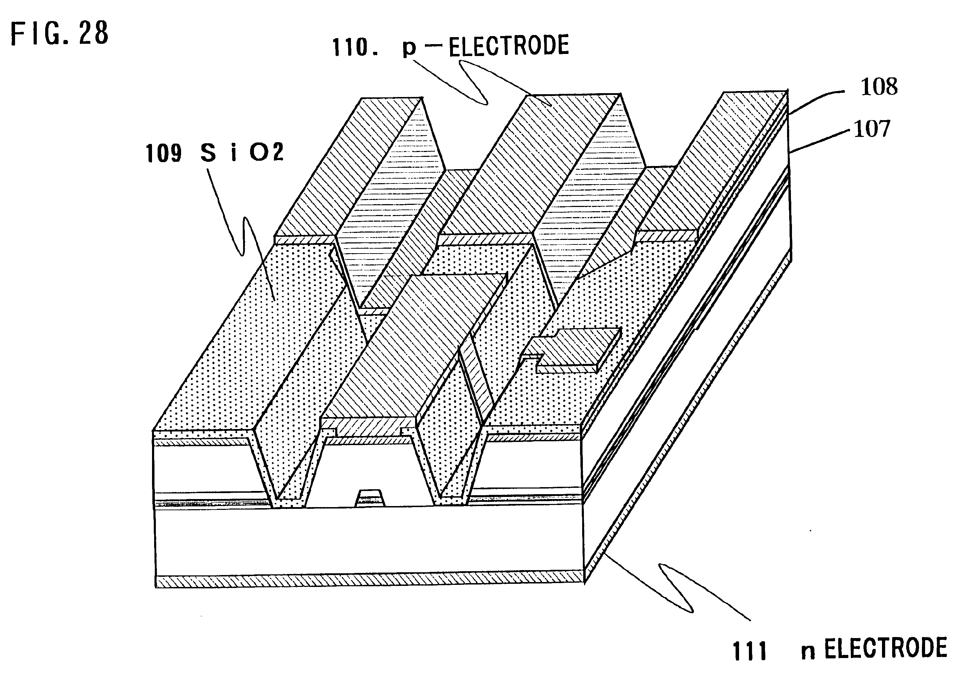

The duty cycles of these diffraction gratings vary in the range from 50% to 35%, or from 50% to 67%, as shown in Fig. 21. Thereby, it is expected that κ =37.5cm⁻¹ can be realized regardless of the oscillation wavelengths. Then, as shown in Figs. 27A through 27C, wherein Fig. 27A is a cross sectional view taken along line C-C' of Fig. 25, SiO₂ portions on both sides of the selective growth layer are partially removed (Fig. 27B), and, as shown in Fig. 27C, a p-InP cladding layer 107 (having a thickness of 1.5 µm, p=1 × 10¹⁸cm⁻³) and a p⁺-InGaAs cap layer 108 (having a thickness of 0.25 µm, p=6 × 10¹⁸cm⁻³) are selectively grown by MOVPE. Thereafter, the p⁺-InGaAs cap layer 108 between the DFB laser area and the EA modulator area is removed by 30 µm to realize electrical isolation. As shown in Fig. 28, patterning of p-electrode 110 is performed by using the SiO₂ film 109 as an interlayer film. Further, a back surface polishing is performed until the thickness of the n-InP substrate 101 becomes 120 µm, and an n-type electrode 111 is formed on the back surface of the n-InP substrate 101. Then, each portion having a total length of 600 *µ* m including the DFB laser portion having a length of 400 µm and the EA modulator portion having a length of 200 µm was cut out. A high reflectance film having a reflectance of 95% was coated on the end facet on the DFB laser side, and an anti-reflective film having a reflectance equal to or lower than 0.1% was coated on the end facet on the modulator side. Evaluation of the obtained elements was done to obtain element characteristics.

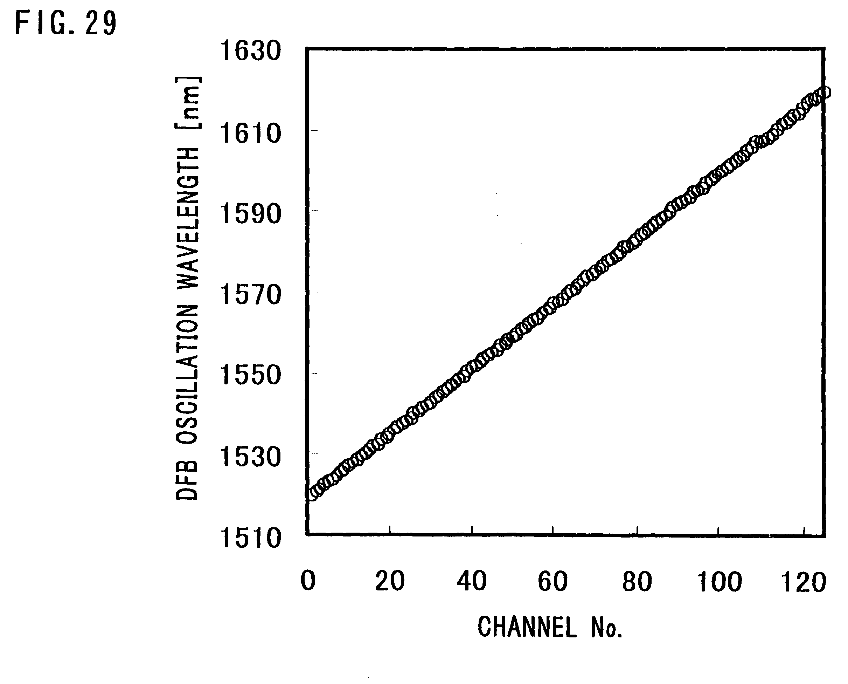

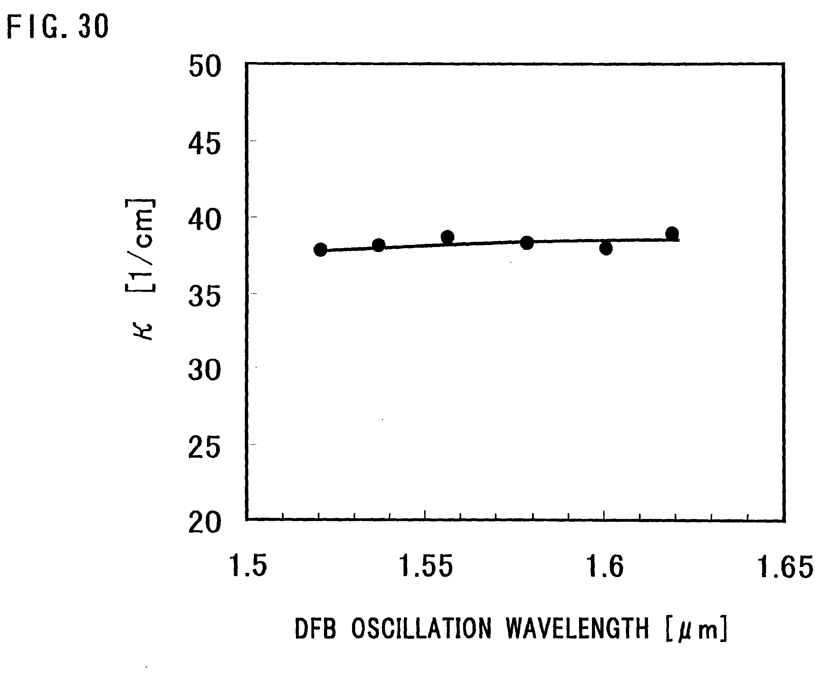

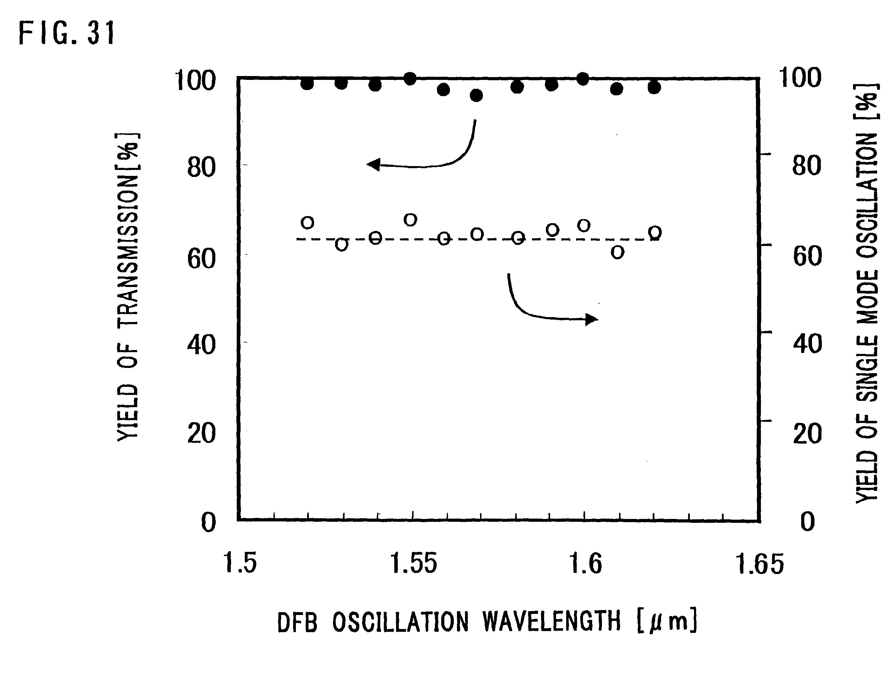

First, inspection was done on oscillation wavelength characteristics of the EA modulator integrated DFB lasers having different wavelengths which were formed together. Fig. 29 shows oscillation wavelengths of 125 elements of the fabricated DFB lasers in order. It was confirmed that the wavelength becomes longer from channel 1 to channel 125 at a slope of 0.8nm/channel which is approximately similar to the designed value, and that elements having different wavelengths covering a range from 1520 to 1620nm (from 1.52 to 1.62 µm) are realized on one substrate. Then, the κ was evaluated for the elements having different DFB oscillation wavelengths. As a result, as shown in Fig. 30, it was confirmed that the κ was kept approximately at the designed value of 37.5cm⁻¹ and did not depend on the oscillation wavelength. This shows a result obtained by sufficiently realizing an effect of the present invention which is provided by changing the duty cycles of the diffraction gratings depending on the oscillation wavelengths. The prior art fabrication method has a disadvantage in that the κ varies depending on the oscillation wavelengths. Therefore, as shown in Fig. 31, the yield of single longitudinal mode oscillation does not depend on the oscillation wavelength and is kept equal to or higher than 60%. Also, the transmission yield (the yield of single mode oscillation) obtained under the standard in which the power penalty after the transmission of 600km at 2.5Gb/s modulation is equal to or lower than 1dB was 95% or more for all the oscillation wavelengths.

Next, an explanation will be made on a method of manufacturing DFB lasers having different wavelengths together according to the second embodiment.

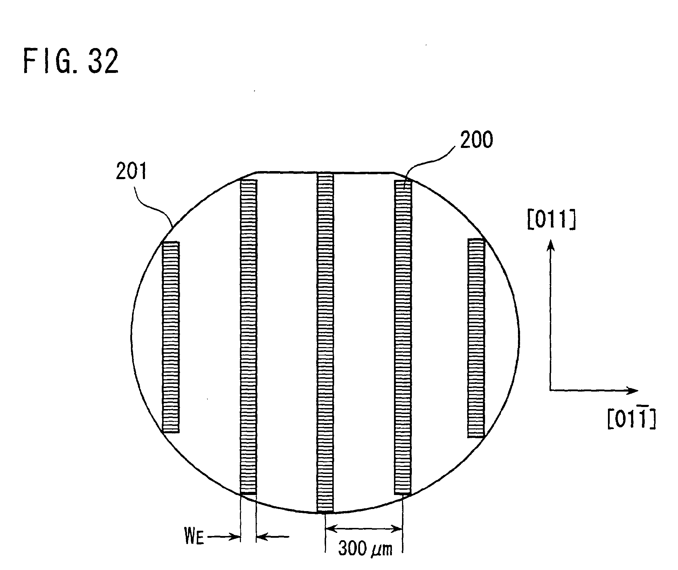

First, in a manner similar to the first embodiment, diffraction gratings are formed by using an electron beam exposure method and by etching on a (100)n-InP substrate 201. In this case, as shown in Fig. 32, the diffraction gratings 200 are formed in whole areas along [011] direction, and formed in patterns in which diffraction gratings are repeatedly formed at a pitch of 300 µm in [01-1] direction. When realizing the DFB lasers having different wavelengths, in order to control oscillation wavelengths of the DFB lasers, pitches Λ of the diffraction gratings were changed from 235.05 to 250.85nm as shown in Fig. 20, and, by changing electron dosage, the duty cycles of the diffraction gratings were changed in a range from 50% to 35%, or from 50% to 67%, as shown in Figs. 21A and 21B, according to the oscillation wavelength of the DFB laser, or the mask width in the selective growth as described below. In this embodiment, quantity of etching was controlled such that the height of the diffraction gratings becomes 30nm, in an etching process corresponding to that shown in Fig. 15D.

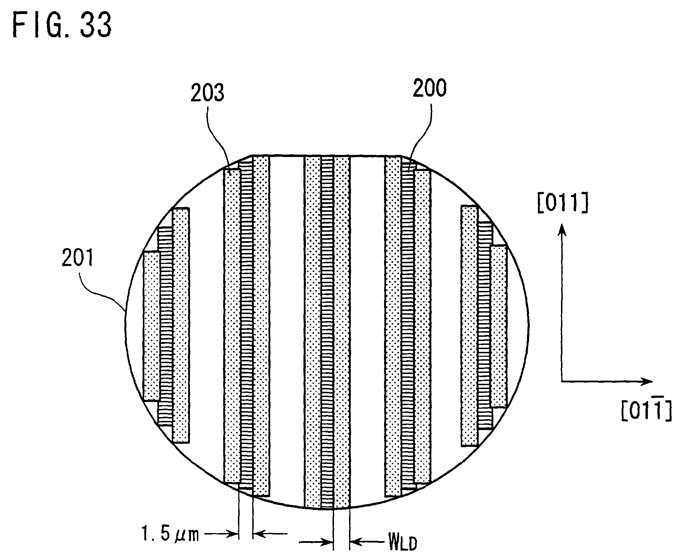

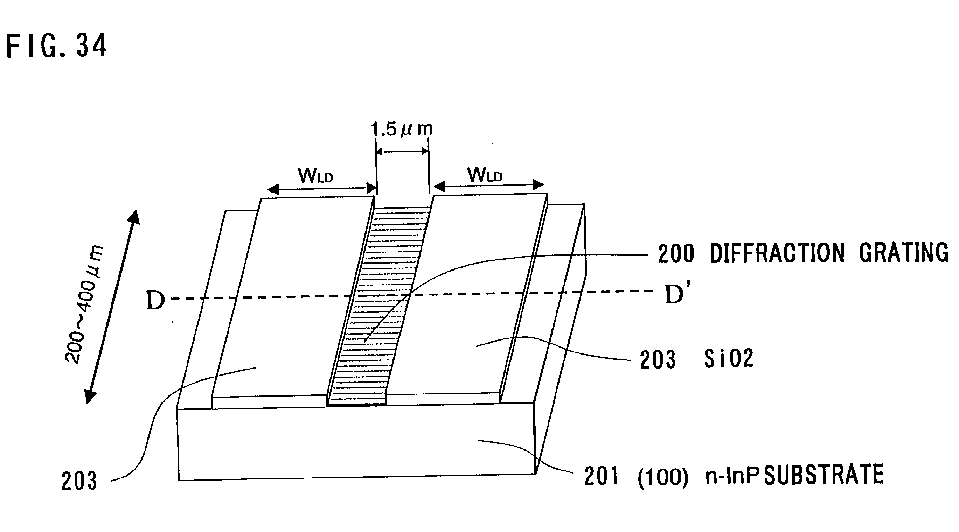

Next, as shown in Fig. 33, a pair of SiO₂ stripe masks 203 for the selective MOVPE growth are formed on both sides of the diffraction gratings 200 by patterning. Here, a mask width was set to W_{LD}. Fig. 34 represents the SiO₂ mask patterns for only one element. In this structure, the space between a pair of stripe masks had a fixed value of 1.5 µm. Also, the design values for W_{LD} with respect to the DFB oscillation wavelengths were the same as those of the first embodiment shown in Fig. 24. Fig. 20, Figs. 21A and 21B and Fig. 24 show the pitches Λ of the diffraction gratings, the duty cycles of the diffraction gratings and W_{LD}, respectively, as continuous values with respect to the DFB oscillation wavelengths. However, in practice, the values in the graphs of Fig. 20, Figs. 21A and 21B and Fig. 24 have discontinuous values having 125 steps. This is because, in the present embodiment, a range of the DFB oscillation wavelengths from 1.52 to 1.62 µm is divided into 125 kinds of wavelengths having a space of 100GHz (approximately, a space of 0.8nm) therebetween.

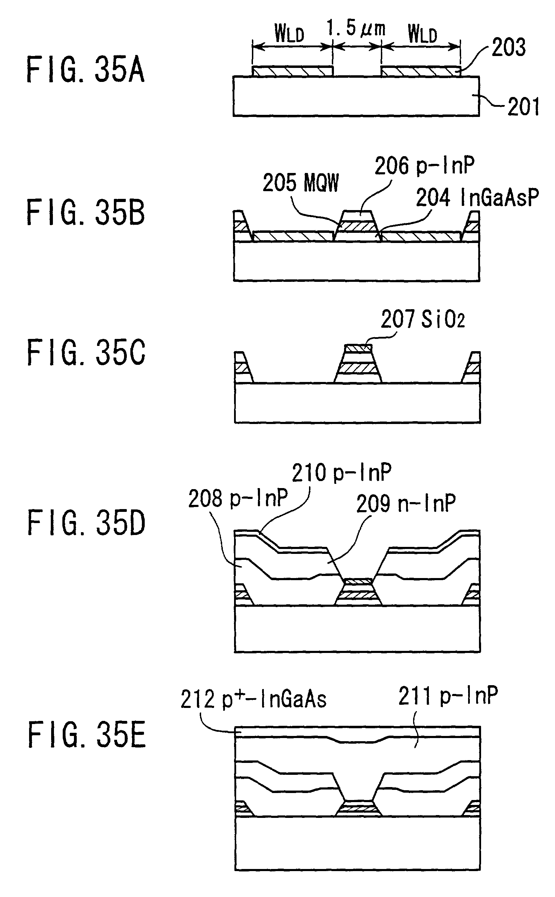

With reference to Figs. 35A through 35E, wherein Fig. 35A shows a cross section taken along line D-D' in Fig. 34, an explanation will be made on the selective MOVPE growth process. First, as shown in Fig. 35B, an n-InGaAsP guide layer (having bandgap wavelength of 1.13 µm, film thickness of 150nm, n=1 × 10¹⁸cm⁻³) 204, a strained MQW layer (5 cycles of well layers: InGaAsP (strain of +0.60%, thickness of 10nm), and barrier layers: InGaAsP (having bandgap wavelength of 1.20 µm, thickness of 9nm)) 205, and p-InP layer (having a thickness of 150nm, p=5 × 10¹⁷cm⁻³) 206 were formed by the selective MOVPE growth, where all these values are values at W_{LD}=15 µm. The height of the diffraction gratings after the selective MOVPE growth is 30nm. The duty cycles of these diffraction gratings vary in the range from 50% to 35%, or from 50% to 67%, as shown in Figs. 21A and 21B. Thereby, it is expected that κ =30cm⁻¹ can be realized regardless of the oscillation wavelengths.

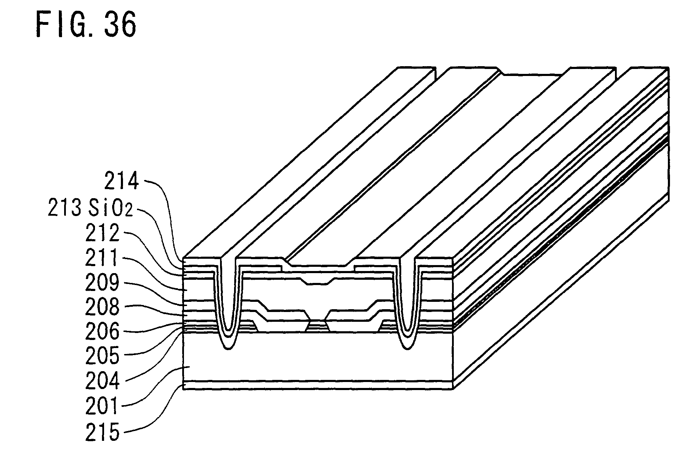

Then, as shown in Fig. 35C, an SiO₂ mask 207 is grown on the selective growth layer, and thereafter, as shown in Fig. 35D, a p-InP block layer 208, an n-InP block layer 209, and p-InP layer 210 are selectively grown. Finally, after removing the SiO₂ mask 207, a p-InP cladding layer 211 and a p⁺-InGaAs cap layer 212 are formed by the selective MOVPE growth. The process shown by Fig. 35D through Fig. 35E are described in detail in IEEE JOURNAL OF QUANTUM ELECTRONICS, Vol. 35, No. 3, pp. 368-376. Thereafter, as shown in Fig. 36, patterning of p-electrode 214 is performed by using the SiO₂ film 213 as an interlayer film. Further, a back surface polishing is performed until the thickness of the n-InP substrate 201 becomes 100 µm, and an n-type electrode 215 is formed. Then, each portion having a length of 400 µm was cut out as an element. A high reflectance film having a reflectance of 95 % was coated on the back end facet of the DFB laser, and an anti-reflective film having a reflectance equal to or lower than 0.1% was coated on the front end facet thereof. Evaluation of the obtained elements was done to obtain element characteristics.

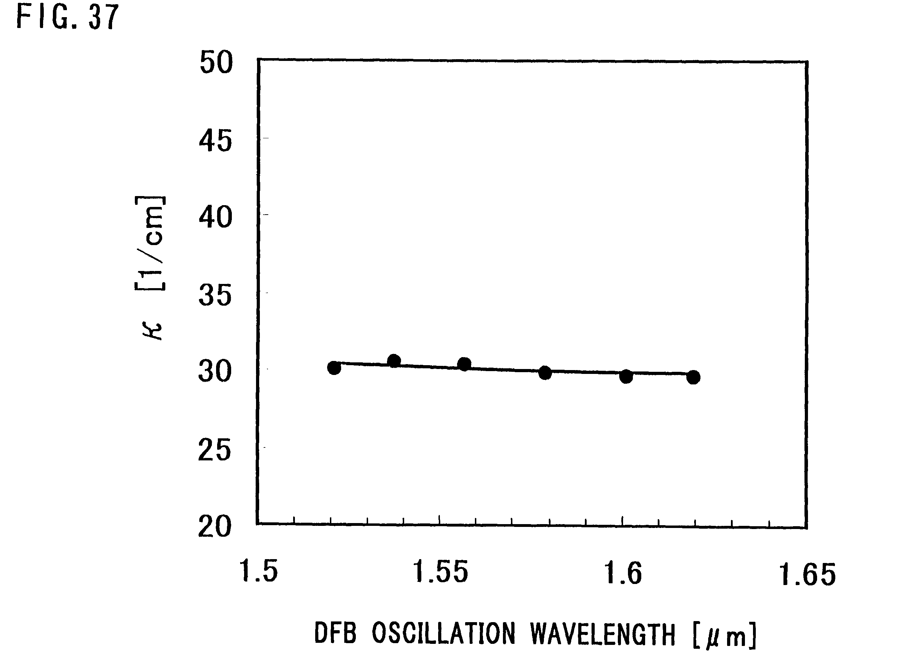

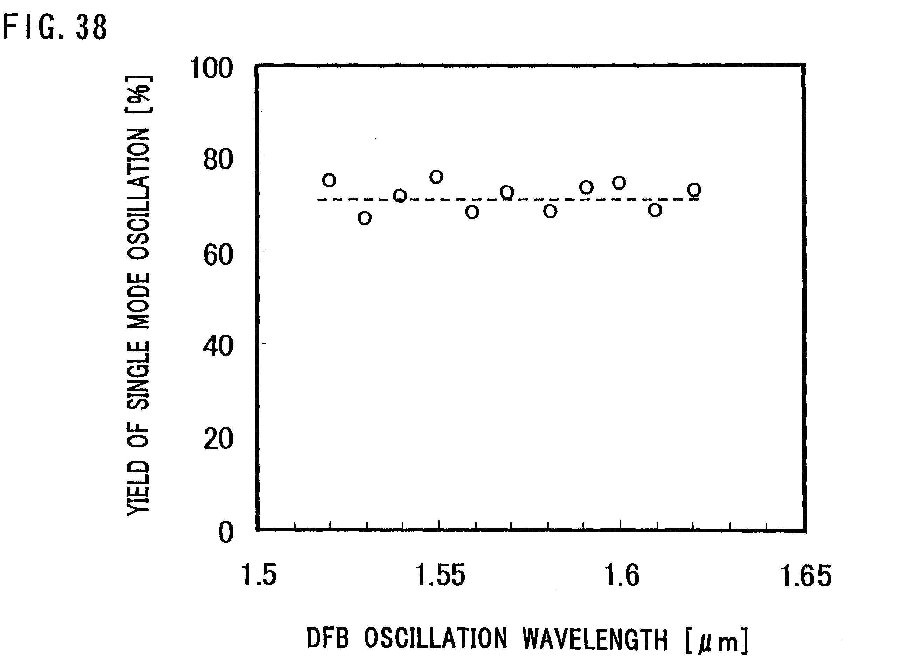

First, inspection was done on oscillation wavelength characteristics of the DFB lasers having different wavelengths which were formed together. Fig. 29 shows oscillation wavelengths of 125 elements of the fabricated DFB lasers in order. It was confirmed that the wavelength becomes longer from channel 1 to channel 125 at a slope of 0.8nm/channel which is approximately similar to the designed value, and that elements having different wavelengths covering a range from 1520 to 1620nm (from 1.52 to 1.62 µm) are realized on one substrate. Then, the κ was evaluated for the elements having different DFB oscillation wavelengths. As a result, as shown in Fig. 37, it was confirmed that the coupling coefficient was kept approximately at the designed value of 30.0cm⁻¹ and did not depend on the oscillation wavelength. This shows a result obtained by sufficiently realizing an effect of the present invention which is provided by changing the duty cycles of the diffraction gratings depending on the oscillation wavelengths. The prior art fabrication method has a disadvantage in that the *κ* varies depending on the oscillation wavelengths. As a result, highly uniform characteristics were obtained for the elements of all the oscillation wavelengths. That is, the laser oscillation threshold value was 5.0+/-0.25mA, efficiency was 0.35+/-0.05W/A, and the maximum optical output was 160+/-3mW. Also, as shown in Fig. 38, the yield of single longitudinal mode oscillation does not depend on the oscillation wavelength and is kept equal to or higher than 65%.

With reference to Figs. 18A and 18B, an explanation will now be made on a method of manufacturing integrated EA modulator type DFB lasers having different wavelengths together, which are different from those of the first embodiment, as a third embodiment. First, a positive resist 102 having electron beam sensitivity is applied on a (100)n-InP substrate 101. Then, patterns shown in Fig. 18A are written by an electron beam exposure method. Thereafter, the n-InP substrate 101 is etched by using the resist 102 as a mask and by using etching solution of HBr:H₂O₂ system. Thereby, a diffraction grating as shown in Fig. 18B is fabricated. Fig. 16 corresponds to a cross sectional view taken along a line B-B' of Fig. 18B.

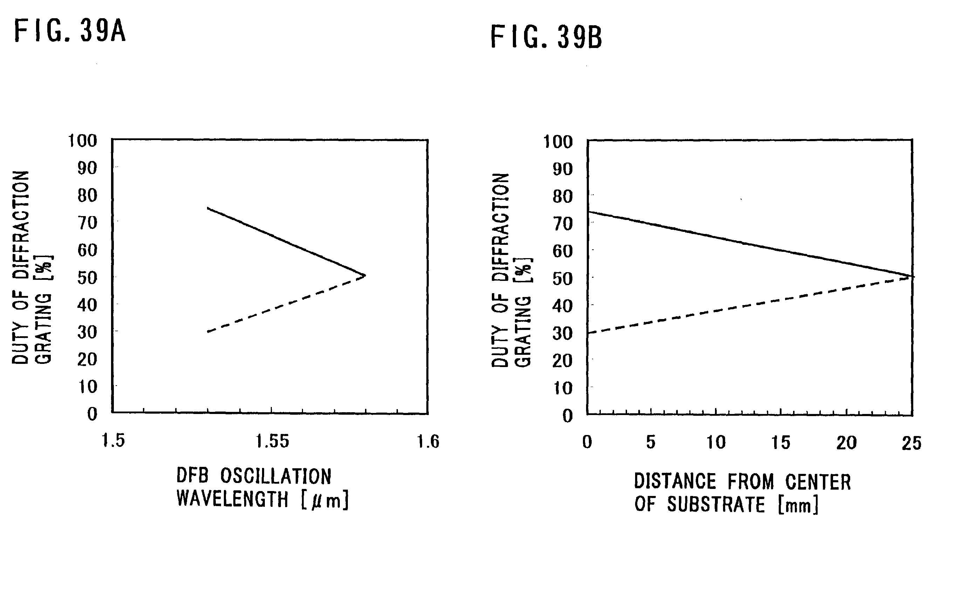

The diffraction gratings are formed in patterns in which diffraction grating formed areas each having 800 µm in length and unformed areas each having 400 µm in length between the diffraction gratings are repeated in [011] direction, and in patterns in which diffraction gratings are repeatedly formed at a pitch of 300 µm in [01-1] direction. When realizing EA modulator integrated type DFB lasers, in order to control oscillation wavelengths of the DFB lasers, pitches Λ of the diffraction gratings were changed from 236.60 to 244.65nm and, as shown in Fig. 20, the DFB oscillation wavelengths from 1.53 µm to 1.58 µm were obtained. Also, by changing electron dosage, the duty cycles of the diffraction gratings were changed in a range from 75% to 50%, or from 30% to 50%, as shown in Figs. 39A and 39B, according to the oscillation wavelength of the DFB laser, or according to the distance from the center of a semiconductor substrate, as described below.

Next, as shown in Fig. 22, a pair of SiO₂ stripe masks for the selective MOVPE growth are patterned so as to synchronize with the diffraction gratings 100. Mask widths are set to W_{LD} in each area where the diffraction grating is formed, and to W_{MOD} in each area where the diffraction grating is not formed. Fig. 23 represents the SiO₂ mask patterns for only one element. That is, an area A1 having the mask width W_{LD} (having a length of 400 µm) corresponds to a portion which becomes a DFB laser, and an area A2 having the mask width W_{MOD} (having a length of 200 µm) corresponds to a portion which becomes an EA modulator. In this structure, the space between a pair of stripe masks had a fixed value of 1.5 µm. Also, W_{LD} was 16 µm, and W_{MOD} was a constant value of 6 µm.

Fig. 20, Figs. 39A and Fig. 39B show the pitches Λ of the diffraction gratings and the duty cycles of the diffraction gratings, respectively, as continuous values with respect to the DFB oscillation wavelengths. However, in practice, the values in the graphs of Fig. 20, Fig. 39A and Fig. 39B have discontinuous values having 62 steps. This is because, in the present embodiment, a range of the DFB oscillation wavelengths from 1.53 to 1.58 µm is divided into 62 kinds of wavelengths having a space of 100GHz (approximately, a space of 0.8nm) therebetween.

By using the substrate having the SiO₂ patterns mentioned above, a laser active layer and a modulator absorption layer were grown thereon by the selective MOVPE growth, as shown in Fig. 25. As mentioned before, in the MOVPE growth, a vertical reactor was used, and a condition was adopted such that a distribution of grown film thickness as shown in Fig. 7 was obtained by adjusting carrier gas flow rate. Selective growth layers included an n-InGaAsP guide layer (having bandgap wavelength of 1.26 µm, film thickness of 150nm, n=1 × 10¹⁸cm⁻³) 104, a strained MQW layer (8 cycles of well layers: InGaAsP (strain of +0.60%, thickness of 10nm), and barrier layers: InGaAsP (having bandgap wavelength of 1.20 µm, thickness of 9nm)) 105, and p-InP layer (having a thickness of 150nm, p=5 × 10¹⁷cm⁻³) 106, where all these values are values at the center of the substrate. As a result, a distribution of photoluminescence wavelengths within a surface at W_{LD} (=16 µm) and W_{MOD} (=6 µm) became 1.53-1.58 µm and 1.46-1.51 µm as shown in Fig. 8. Fig. 26 is a cross sectional view taken along line A-A' of Fig. 25, and shows a structure in which a diffraction grating exists in an area of a DFB laser.

The duty cycles of these diffraction gratings vary in the range from 75% to 50%, or from 30% to 50%, as shown in Fig. 39. Thereby, it is expected that κ =37.5cm⁻¹ can be realized regardless of the oscillation wavelengths. Then, as shown in Fig. 27 which includes cross sectional views taken along line C-C' of Fig. 25, SiO₂ portions on both sides of the selective growth layer are partially removed (Fig. 27(b)), and, as shown in Fig. 27(c), a p-InP cladding layer 107 (having a thickness of 1.5 µm, p=1 × 10¹⁸cm⁻³) and a p⁺-InGaAs cap layer 108 (having a thickness of 0.25 µm, p=6 × 10¹⁸cm⁻³) are selective MOVPE grown. Thereafter, the p⁺-InGaAs cap layer 108 between the DFB laser area and the EA modulator area is removed by 30 µm to obtain electrical isolation. As shown in Fig. 28, patterning of p-electrode 110 is performed by using the SiO₂ film 109 as an interlayer film. Further, a back surface polishing is performed until the thickness of the n-InP substrate 101 becomes 120 µm, and an n-type electrode 111 was formed. Then, each portion having a total length of 600 µm including the DFB laser portion 400 having a length of 400 µm and the EA modulator portion having a length of 200 µm was cut out. A high reflectance film having a reflectance of 95% was coated on the end facet on the DFB laser side, and an anti-reflective film having a reflectance equal to or lower than 0.1% was coated on the end facet on the modulator side. Evaluation of the obtained elements was done to obtain element characteristics.

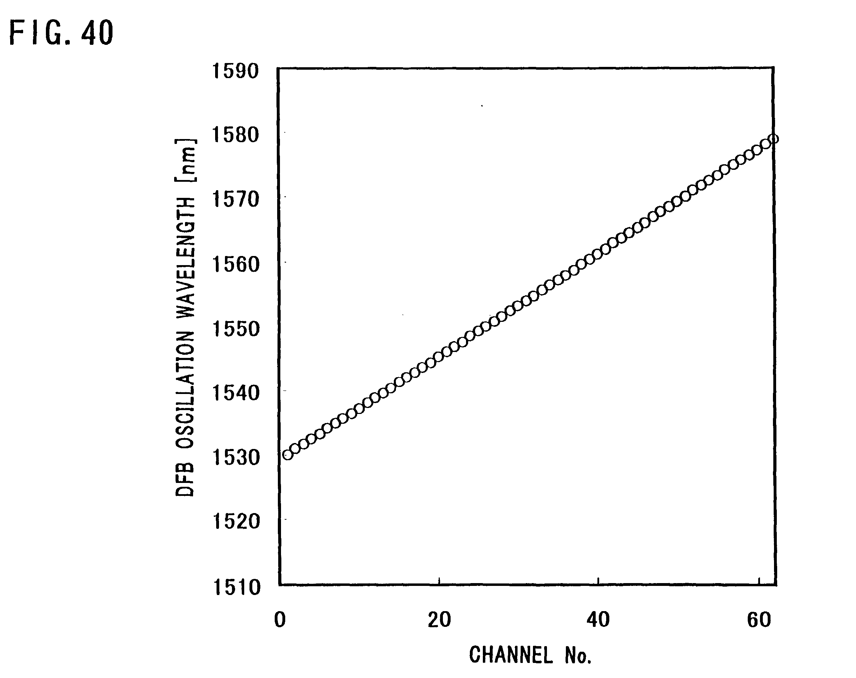

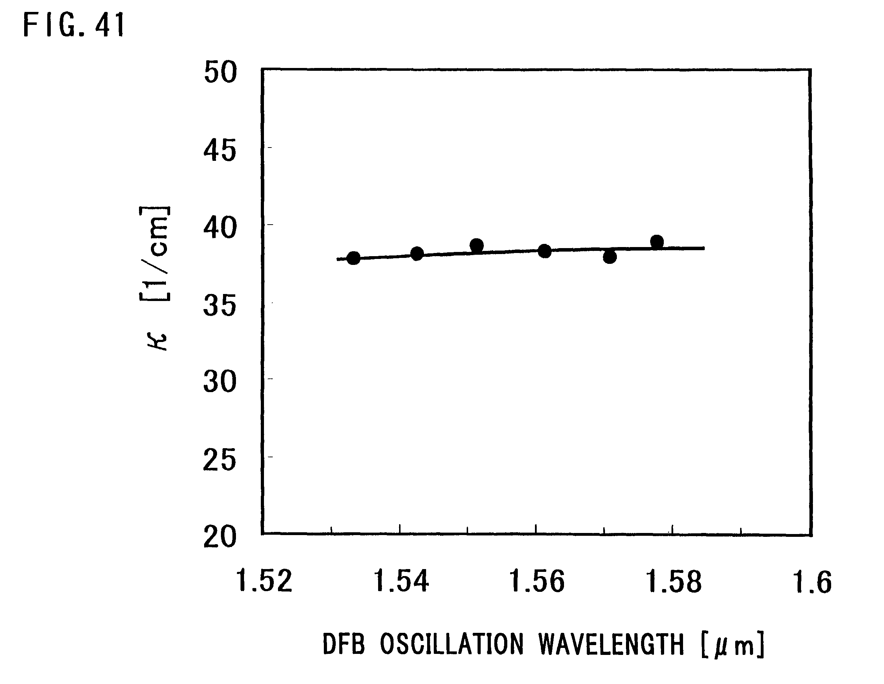

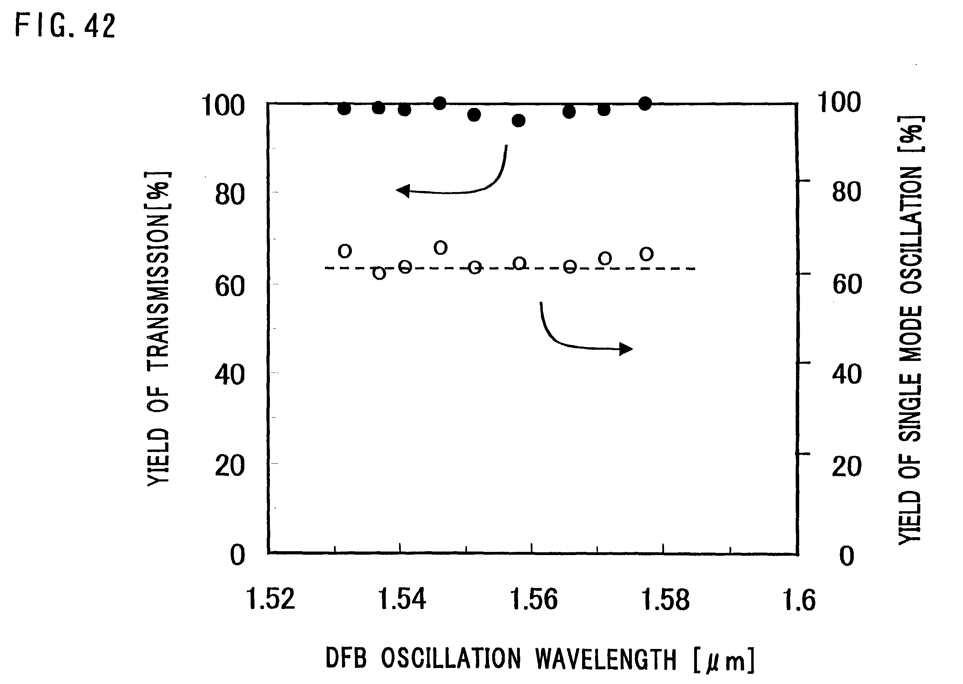

First, inspection was done on oscillation wavelength characteristics of the EA modulator integrated DFB lasers having different wavelengths which were formed together. Fig. 40 shows oscillation wavelengths of 62 elements of the fabricated DFB lasers in order. It was confirmed that the wavelength becomes longer from channel 1 to channel 62 at a slope of 0.8nm/channel which is approximately similar to the designed value, and that elements having different wavelengths covering a range from 1530 to 1580nm (from 1.53 to 1.58 µm) are realized on one substrate. Then, the κ was evaluated for the elements having different DFB oscillation wavelengths. As a result, as shown in Fig. 41, it was confirmed that the κ was kept approximately at the designed value of 37.5cm⁻¹ and did not depend on the oscillation wavelength. This shows a result obtained by sufficiently realizing an effect of the present invention which is provided by changing the duty cycles of the diffraction gratings depending on the oscillation wavelengths. The prior art fabrication method has a disadvantage in that the κ varies depending on the oscillation wavelengths. Therefore, as shown in Fig. 42, the yield of single longitudinal mode oscillation does not depend on the oscillation wavelength and is kept equal to or higher than 60%. Also, the long-haul transmission yield obtained under the standard in which the power penalty after the transmission of 600km at 2.5Gb/s modulation is equal to or lower than 1dB was 95% or more for all the oscillation wavelengths, and a preferable result was obtained.

Now, an explanation will now be made on a method of manufacturing integrated EA modulator type DFB lasers having different wavelengths together, which are different from those of the first and third embodiments, as a fourth embodiment. First, as shown in Fig. 18, positive resist 102 having electron beam sensitivity is applied on a (100)n-InP substrate 101. Then, patterns shown in Fig. 18A are written by an electron beam exposure method. Thereafter, the n-InP substrate 101 is etched by using the resist 102 as a mask and by using etching solution of HBr:H₂O₂ system. Thereby, a diffraction grating as shown in Fig. 18B was fabricated. Fig. 16 corresponds to a cross sectional view taken along a line B-B' of Fig. 18B.

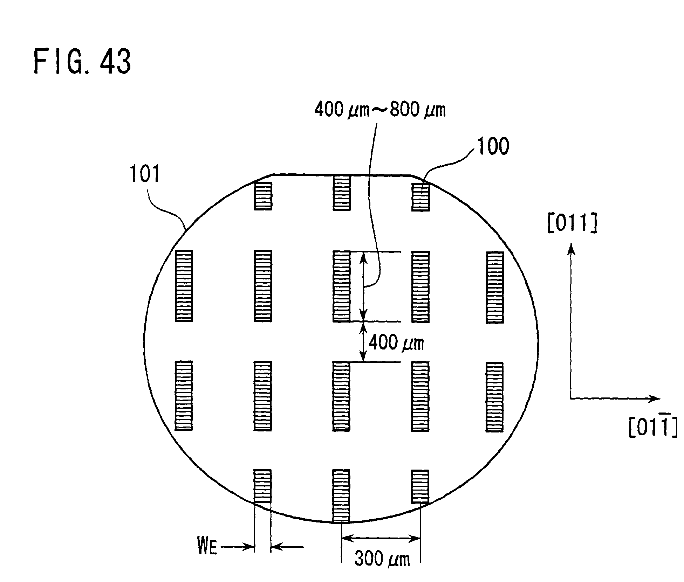

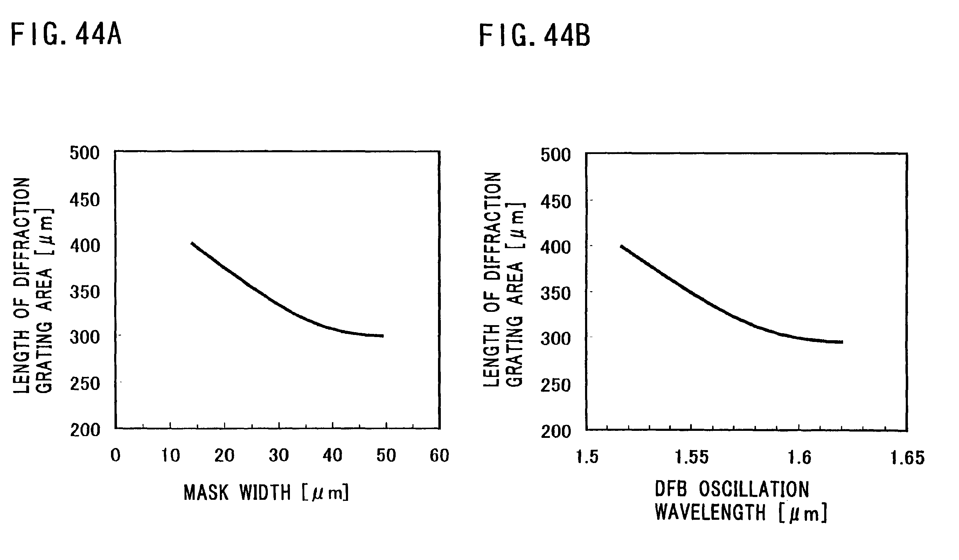

As shown in Fig. 43, the diffraction gratings are formed in patterns in which diffraction grating formed areas each having 400-800 µm in length and unformed areas each having 400 µm in length between the diffraction gratings are repeated in [011] direction, and in patterns in which diffraction gratings are repeatedly formed at a pitch of 300 µm in [01-1] direction. As shown in Figs. 44A and 44B, the diffraction grating formed area was changed according to the mask width for the selective growth of the DFB laser portion or the oscillation wavelength of the DFB laser. When realizing EA modulator integrated type DFB lasers, in order to control oscillation wavelengths of the DFB lasers, pitches Λ of the diffraction gratings were changed from 235.05 to 250.85nm as shown in Fig. 20, and the duty cycle of the diffraction gratings was a constant value of 50%.

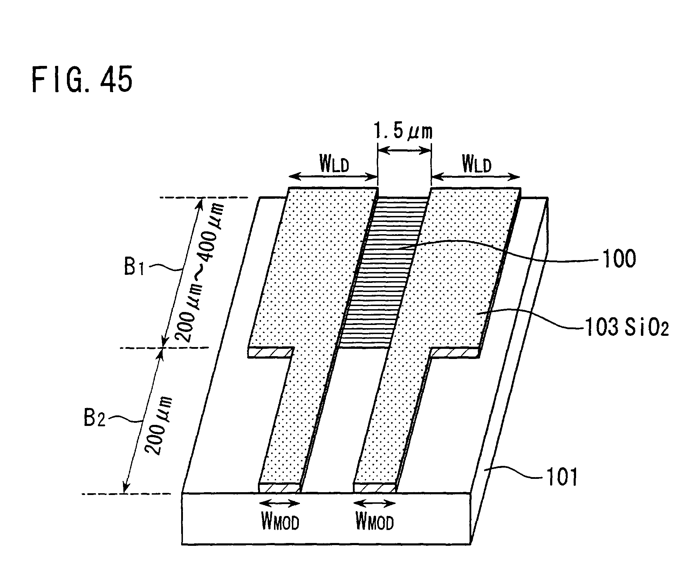

Next, as shown in Fig. 22, a pair of SiO₂ stripe masks 103 for the selective MOVPE growth were patterned so as to synchronize with the diffraction gratings 100. Mask widths were set to W_{LD} in each area where the diffraction grating was formed, and to W_{MOD} in each area where the diffraction grating was not formed. Fig. 45 represents the SiO₂ mask patterns for only one element. That is, an area B1 having the mask width W_{LD} (having a length of 200-400 µm) corresponds to a portion which becomes a DFB laser, and an area B2 having the mask width W_{MOD} (having a length of 200 µm) corresponds to a portion which becomes an EA modulator. In this structure, the space between a pair of stripe masks had a fixed value of 1.5 µm. Fig. 24 shows design values for W_{LD} and W_{MOD} with respect to the DFB oscillation wavelengths.

Fig. 20, Fig. 44A, Fig. 44B and Fig. 24 show the pitches Λ of the diffraction gratings, the lengths of the diffraction grating formed areas, W_{LD} and W_{MOD}, respectively, as continuous values with respect to the DFB oscillation wavelengths. However, in practice, the values in the graphs of Fig. 20, Fig. 44A, Fig. 44B and Fig. 24 have discontinuous values having 125 steps. This is because, in the present embodiment, a range of the DFB oscillation wavelengths from 1.52 to 1.62 µm is divided into 125 kinds of wavelengths having a space of 100GHz (approximately, a space of 0.8nm) therebetween.

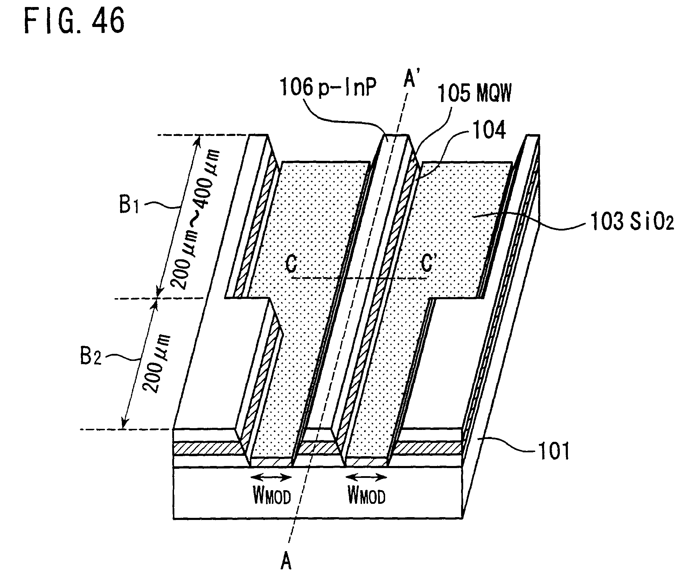

By using the substrate having the SiO₂ patterns mentioned above, a laser active layer and a modulator absorption layer were grown thereon by the selective MOVPE growth, as shown in Fig. 46. Selective growth layers included an n-InGaAsP guide layer (having bandgap wavelength of 1.13 *µ* m, film thickness of 150nm, n=1 × 10¹⁸cm⁻³) 104, a strained MQW layer (8 cycles of well layers: InGaAsP (strain of +0.60%, thickness of 10nm), and barrier layers: InGaAsP (having bandgap wavelength of 1.20 µm, thickness of 9nm)) 105, and p-InP layer (having a thickness of 150nm, p=5 × 10¹⁷cm⁻³) 106, where all these values are values at W_{LD}=15 µm. Fig. 26 is a cross sectional view taken along line A-A' of Fig. 46, and shows a structure in which a diffraction grating exists in an area of a DFB laser.

As a result, a distribution of photoluminescence wavelengths within a surface at W_{LD} (=16 µm) and W_{MOD} (=6 µm) became 1.52-1.62 µm and 1.45-1.55 µm as shown in Fig. 8. Fig. 26 is a cross sectional view taken along line A-A' of Fig. 46, and shows a structure in which a diffraction grating exists in an area of a DFB laser.

The lengths of the diffraction grating forming areas vary in the range from 400 to 200 µm, as shown in Figs. 44A and 44B. Thereby, it is expected that κL=1.5 can be realized regardless of the oscillation wavelengths. Then, as shown in Figs. 27A through 27C wherein Fig. 27A is a cross sectional view taken along line C-C' of Fig. 46, SiO₂ portions on both sides of the selective growth layer are partially removed (Fig. 27B), and, as shown in Fig. 27C, a p-InP cladding layer 107 (having a thickness of 1.5 µm, p=1 × 10¹⁸cm⁻³) and a p⁺-InGaAs cap layer 108 (having a thickness of 0.25 µm, p=6 × 10¹⁸cm⁻³) are selective MOVPE grown. Thereafter, the p⁺-InGaAs cap layer 108 between the DFB laser area and the EA modulator area is removed by 30 µm to obtain electrical isolation. As shown in Fig. 28, patterning of p-electrode 110 is performed by using the SiO₂ film 109 as an interlayer film. Further, a back surface polishing is performed until the thickness of the n-InP substrate 101 becomes 120 µm, and an n-type electrode 111 was formed. Then, each portion having a total length of 400-600 µm including the DFB laser portion having a length of 200-400 µm and the EA modulator portion having a length of 200 µm was cut out. A high reflectance film having a reflectance of 95 % was coated on the end facet on the DFB laser side, and an anti-reflective film having a reflectance equal to or lower than 0.1% was coated on the end facet on the modulator side. Evaluation of the obtained elements was done to obtain element characteristics.

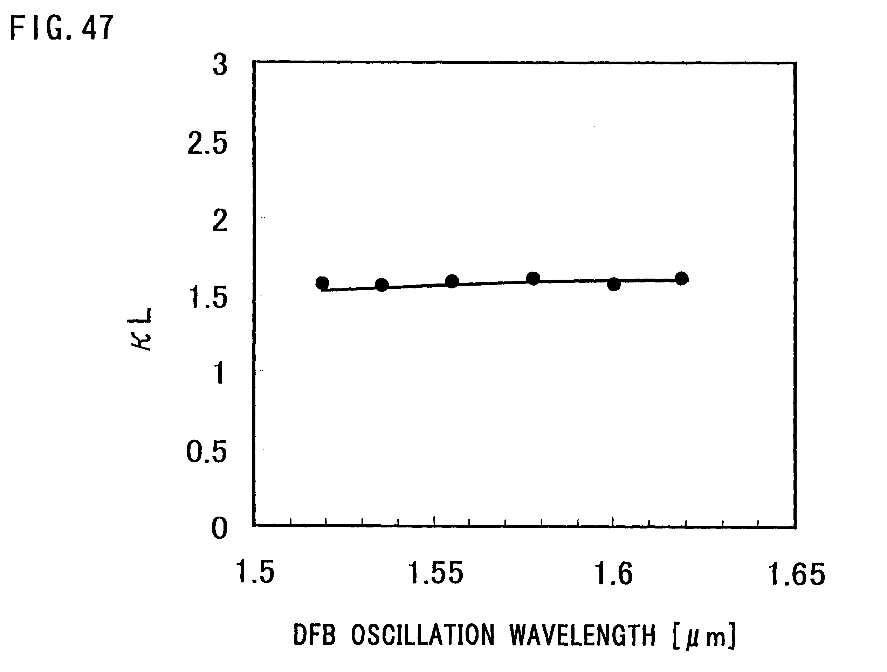

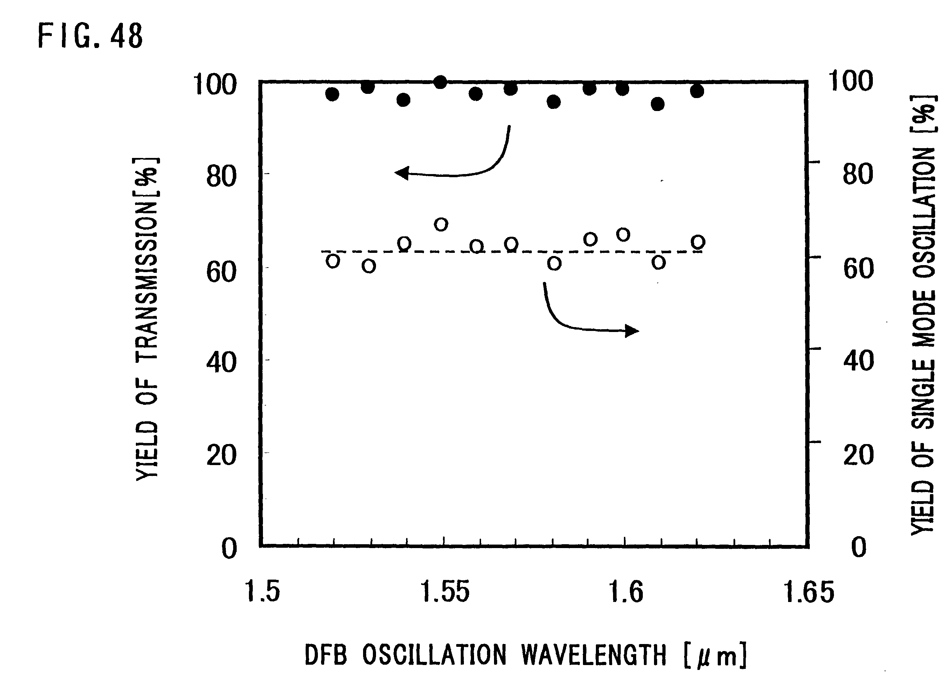

First, inspection was done on oscillation wavelength characteristics of the EA modulator integrated DFB lasers having different wavelengths which were formed together. Fig. 29 shows oscillation wavelengths of 125 elements of the fabricated DFB lasers in order. It was confirmed that the wavelength becomes longer from channel 1 to channel 125 at a slope of 0.8nm/channel which is approximately similar to the designed value, and that elements having different wavelengths covering a range from 1520 to 1620nm (from 1.52 to 1.62 µm) are realized on one substrate. Then, the κL was evaluated for the elements having different DFB oscillation wavelengths. As a result, as shown in Fig. 47, it was confirmed that the κL was kept approximately at the designed value of 1.5 and did not depend on the oscillation wavelength. This shows a result obtained by sufficiently realizing an effect of the present invention which is provided by changing the length of the diffraction grating forming area depending on the oscillation wavelengths. The prior art fabrication method has a disadvantage in that the κ L varies depending on the oscillation wavelengths. Therefore, as shown in Fig. 48, the yield of single longitudinal mode oscillation does not depend on the oscillation wavelength and is kept equal to or higher than 60%. Also, the long-haul transmission yield obtained under the standard in which the power penalty after the transmission of 600km at 2.5Gb/s modulation is equal to or lower than 1dB was 95 % or more for all the oscillation wavelengths.

In a method of manufacturing an optical semiconductor device according to the present invention, when DFB lasers having different wavelengths or EA modulator integrated lasers having different wavelengths are fabricated together by using a selective MOVPE method, duty cycles of diffraction gratings are increased or decreased from 50 %, depending on oscillation wavelengths, widths of dielectric masks used for selective growth, or locations on a semiconductor substrate. Thereby, coupling coefficients are maintained approximately constant, or products of the coupling coefficients and lengths of area of forming diffraction gratings or lengths of elements are maintained substantially constant.

Therefore, it is possible to uniformalize laser oscillation thresholds, light emission efficiency and long-haul transmission characteristics and to improve the yield of single longitudinal mode oscillation.

In the foregoing specification, the invention has been described with reference to specific embodiments. However, one of ordinary skill in the art appreciates that various modifications and changes can be made without departing from the scope of the present invention as set forth in the claims below. Accordingly, the specification and figures are to be regarded in an illustrative sense rather than a restrictive sense, and all such modifications are to be included within the scope of the present invention. Therefore, it is intended that this invention encompasses all of the variations and modifications as fall within the scope of the appended claims.

## Claims

1. A set of semiconductor laser elements which perform single longitudinal mode oscillation by having periodically varying refractive index within said elements and which are formed together from one semiconductor substrate, said semiconductor laser elements having mutually different oscillation wavelengths, **characterized in that** each of said semiconductor laser elements comprises a diffraction grating, and a duty cycle of said diffraction grating varies so as to realize equal coupling coefficient.

2. A set of semiconductor laser elements as set forth in claim 1, wherein said duty cycle of said diffraction grating varies depending on said oscillation wavelength.

3. A set of semiconductor laser elements as set forth in claim 1, wherein each of said semiconductor laser elements comprises a distributed feedback (DFB) type semiconductor laser and an electro-absorption (EA) type optical modulator formed integrally.

4. A set of semiconductor laser elements as set forth in claim 1, wherein said duty cycle of said diffraction grating is increased or decreased from 50%.

5. A set of semiconductor laser elements which perform single longitudinal mode oscillation by having periodically varying refractive index within said elements and which are formed together from one semiconductor substrate, said semiconductor laser elements having mutually different oscillation wavelengths, **characterized in that** each of said semiconductor laser elements comprises a diffraction grating, and a product of a coupling coefficient and a length of area in which said diffraction grating is formed in each of said semiconductor laser elements or a product of a coupling coefficient and a length of each of said elements is substantially constant.

6. A set of semiconductor laser elements as set forth in claim 5, wherein said length of area in which said diffraction grating is formed or said length of said element varies depending on each of said oscillation wavelengths

7. A set of semiconductor laser elements as set forth in claim 5, wherein each of said semiconductor laser elements comprises a distributed feedback (DFB) type semiconductor laser and an electro-absorption (EA) type optical modulator formed integrally.

8. A method of manufacturing a set of semiconductor laser elements which perform single longitudinal mode oscillation by having periodically varying refractive index within said elements and which are formed together from one semiconductor substrate, said semiconductor laser elements having mutually different oscillation wavelengths, **characterized in that** said method comprises forming a diffraction grating for each of said semiconductor laser elements such that a duty cycle of said diffraction grating varies to realize equal coupling coefficient.

9. A method of manufacturing a set of semiconductor laser elements as set forth in claim 8, wherein said duty cycle of said diffraction grating varies depending on said oscillation wavelengths.

10. A method of manufacturing a set of semiconductor laser elements as set forth in claim 8, wherein said duty cycle of said diffraction grating varies depending on a width of a mask for selective growth of a laser element.

11. A method of manufacturing a set of semiconductor laser elements as set forth in claim 8, wherein said duty cycle of said diffraction grating varies depending on a location on said semiconductor substrate.

12. A method of manufacturing a set of semiconductor laser elements as set forth in claim 8, wherein said forming a diffraction grating for each of said semiconductor laser elements comprises:
forming an electron beam sensitive resist film on a semiconductor substrate;
patterning said electron beam sensitive resist film by electron beam exposure; and
etching said semiconductor substrate by using said patterned electron beam sensitive resist film as a mask to produce said diffraction grating for each of said semiconductor laser elements;
wherein said duty cycle of said diffraction grating is changed by changing an electron beam dosage in said electron beam exposure.

13. A method of manufacturing a set of semiconductor laser elements as set forth in claim 8, wherein, in each of said semiconductor laser elements, a distributed feedback (DFB) type semiconductor laser and an electro-absorption (EA) type optical modulator are formed integrally.

14. A method of manufacturing a set of semiconductor laser elements which perform single longitudinal mode oscillation by having periodically varying refractive index within said elements and which are formed together from one semiconductor substrate, said semiconductor laser elements having mutually different oscillation wavelengths, **characterized in that** said method comprises forming a diffraction grating for each of said semiconductor laser elements, wherein a length of area in which said diffraction grating is formed or a length of said element is adjusted every element such that a product of a coupling coefficient and said length of area in which said diffraction grating is formed in each of said semiconductor laser elements or a product of a coupling coefficient and said length of each of said elements becomes substantially constant.

15. A method of manufacturing a set of semiconductor laser elements as set forth in claim 14, wherein said length of area in which said diffraction grating is formed or said length of said element is varied depending on an oscillation wavelength of each laser element.

16. A method of manufacturing a set of semiconductor laser elements as set forth in claim 14, wherein said length of area in which said diffraction grating is formed or said length of said element is varied depending on a width of a mask for selective growth of a laser element.

17. A method of manufacturing a set of semiconductor laser elements as set forth in claim 14, wherein said length of area in which said diffraction grating is formed or said length of said element is varied depending on a location on said semiconductor substrate.

18. A method of manufacturing a set of semiconductor laser elements as set forth in claim 14, wherein, in each of said semiconductor laser elements, a distributed feedback (DFB) type semiconductor laser and an electro-absorption (EA) type optical modulator are formed integrally.
